# EUROPEAN PATENT APPLICATION

(11) **EP 4 738 329 A1**
(43) Date of publication of application: **06.05.2026**
(21) Application number: 25211755.1
(22) Date of filing: 28.10.2025
(51) Int. Cl.: G09G 3/32

(54) **DRIVER, DISPLAY DEVICE INCLUDING DRIVER, AND ELECTRONIC DEVICE INCLUDING DRIVER**

(30) Priority: 30.10.2024 KR 20240150577
(71) Applicant: Samsung Display Co., Ltd., Yongin-si, Gyeonggi-do 17113 (KR)
(72) Inventor: CHO, JAEHYUNG, 17113 Yongin-si (KR); LEE, DONG-HOON, 17113 Yongin-si (KR); JEONG, MINJAE, 17113 Yongin-si (KR); KIM, ILNAM, 17113 Yongin-si (KR); WOO, MINKYU, 17113 Yongin-si (KR); JANG, JAEYONG, 17113 Yongin-si (KR)
(74) Representative: Taor, Simon Edward William

(57) **Abstract**

A driver includes a first gate emission signal generator which generates a first driving signal; a second gate emission signal generator which generates a second driving signal; a clock line which is disposed between the first gate emission signal generator and the second gate emission signal generator and outputs a clock signal; and a low voltage line which is disposed between the first gate emission signal generator and the second gate emission signal generator and outputs a low voltage line. The first gate emission signal generator and the second gate emission signal generator are electrically connected to a same clock line. The first gate emission signal generator and the second gate emission signal generator are electrically connected to a same low voltage line.

## Description

### BACKGROUND

### 1. Technical Field

The disclosure relates to a driver for driving a display panel, a display device including the driver, and an electronic device including the driver.

### 2. Description of the Related Art

The importance of display devices as communication media, has been emphasized because of the increasing developments of information technology. For example, users of display devices such as liquid crystal display (LCD) device, organic light emitting diode (OLED) display device, plasma display panel (PDP) device, quantum dot display device or the like have been increasing and becoming more popular.

The display device may include a display panel and a driver that drives the display panel. The display panel may include gate lines, data lines, emission lines, and pixels. The driver may include a gate driver for providing a gate signal to the gate lines, a data driver for providing a data voltage to the data lines, an emission driver for providing an emission signal to the emission lines, and a controller for controlling the gate driver, the data driver, and the emission driver.

In general, the display device may include a clock line and a voltage transfer line that are connected to the gate driver and the emission driver. As the number of the clock line and the number of the voltage transfer line increases, the integration of the driver may decrease.

It is to be understood that this background of the technology section is, in part, intended to provide useful background for understanding the technology. However, this background of the technology section may also include ideas, concepts, or recognitions that were not part of what was appreciated by those skilled in the pertinent art prior to a corresponding effective filing date of the subject matter disclosed herein.

### SUMMARY

Embodiments provide a driver with improved integration.

Embodiments also provide a display device including the driver.

Embodiments also provide an electronic device including the driver.

However, embodiments of the disclosure are not limited to those set forth herein. The above and other embodiments will become more apparent to one of ordinary skill in the art to which the disclosure pertains by referencing the detailed description of the disclosure given below.

A driver according to an embodiment of the disclosure includes: a first gate emission signal generator which generates a first driving signal; a second gate emission signal generator which generates a second driving signal different from the first driving signal and has a circuit structure substantially identical to a circuit structure of the first gate emission signal generator; a clock line which is disposed between the first gate emission signal generator and the second gate emission signal generator and outputs a clock signal; and a low voltage line which is disposed between the first gate emission signal generator and the second gate emission signal generator and outputs a first low gate voltage. The first gate emission signal generator is electrically connected to the clock line and the low voltage line. The second gate emission signal generator is electrically connected to the clock line and the low voltage line to which the first gate emission signal generator is electrically connected.

In an embodiment, the driver may include a plurality of stages disposed in a direction. The first gate emission signal generator may include a plurality of first gate emission signal generators. The second gate emission signal generator may include a plurality of second gate emission signal generators. Each of the plurality of stages may include a corresponding first gate emission signal generator among the plurality of first gate emission signal generators and a corresponding second gate emission signal generator among the plurality of second gate emission signal generators. The clock line may include a first clock line electrically connected to stages of the plurality of stages, which are disposed at odd-numbered rows, and a second clock line electrically connected to stages of the plurality of stages, which are disposed at even-numbered rows.

In an embodiment, the low voltage line may be disposed between the first clock line and the second clock line in a plan view.

In an embodiment, the low voltage line, the first clock line, and the second clock line may be disposed in a same layer.

In an embodiment, the low voltage line may be disposed in a different layer from the first clock line and the second clock line.

In an embodiment, the low voltage line may at least partially overlap the first clock line or the second clock line in a plan view.

In an embodiment, the low voltage line may be disposed under the first clock line and the second clock line.

In an embodiment, the first gate emission signal generator and the second gate emission signal generator may be line-symmetrical with respect to the low voltage line.

In an embodiment, each of the first gate emission signal generator and the second gate emission signal generator may include an input circuit which outputs an input signal to a control node in response to the clock signal, an inversion circuit which inverts a voltage of the control node and outputs the inverted voltage to an inversion control node, a carry signal output circuit which outputs the first low gate voltage to a carry output node in response to the voltage of the control node and outputs a high gate voltage to the carry output node in response to a voltage of the inversion control node, and a driving signal output circuit which outputs a second low gate voltage different from the first low gate voltage to a driving output node in response to the voltage of the control node and outputs the high gate voltage to the driving output node in response to the voltage of the inversion control node.

In an embodiment, the second low gate voltage may be lower than the first low gate voltage.

A display device according to an embodiment of the disclosure includes: a display panel including a pixel; and a driver which outputs a driving signal to the pixel. The driver includes: a first gate emission signal generator which generates a first driving signal; a second gate emission signal generator which generates a second driving signal different from the first driving signal and has a circuit structure substantially identical to a circuit structure of the first gate emission signal generator; a clock line which is disposed between the first gate emission signal generator and the second gate emission signal generator and outputs a clock signal; and a low voltage line which is disposed between the first gate emission signal generator and the second gate emission signal generator and outputs a first low gate voltage. The first gate emission signal generator is electrically connected to the clock line and the low voltage line. The second gate emission signal generator is electrically connected to the clock line and the low voltage line to which the first gate emission signal generator is electrically connected.

In an embodiment, the low voltage line and the clock line may be disposed in a same layer.

In an embodiment, the low voltage line and the clock line may be disposed in different layers. The low voltage line may at least partially overlap the clock line in a plan view.

In an embodiment, the display panel may include a pixel active pattern disposed on a substrate, a pixel gate electrode disposed on the pixel active pattern, a first pixel output electrode disposed on the pixel gate electrode, and a second pixel output electrode disposed on the pixel gate electrode, a connection electrode disposed on the first pixel output electrode and the second pixel output electrode, and a light-emitting element which is disposed on the connection electrode and emits light.

In an embodiment, the low voltage line, the clock line, and the connection electrode may be disposed in a same layer.

In an embodiment, the low voltage line, the first pixel output electrode, and the second pixel output electrode may be disposed in a same layer. The clock line and the connection electrode may be disposed in a same layer.

In an embodiment, the pixel may include a light-emitting element which emits light, a first pixel transistor which provides a driving current to the light-emitting element, a second pixel transistor which provides a data voltage to the first pixel transistor in response to a write gate signal, a third pixel transistor which diode-connects the first pixel transistor in response to a compensation gate signal, a fourth pixel transistor which provides a first initialization voltage to a gate electrode of the first pixel transistor in response to an initialization gate signal, a fifth pixel transistor which provides a driving voltage to the first pixel transistor in response to an emission signal, a sixth pixel transistor which electrically connects the first pixel transistor and the light-emitting element in response to the emission signal, and a seventh pixel transistor which provides a second initialization voltage to a first electrode of the light-emitting element in response to a bias gate signal.

In an embodiment, the first driving signal may be a driving signal selected from a group consisting of the emission signal, the compensation gate signal, the initialization gate signal, and the bias gate signal. The second driving signal may be different from the first driving signal and may be a driving signal selected from the group consisting of the emission signal, the compensation gate signal, the initialization gate signal, and the bias gate signal.

In an embodiment, the driver may include a first driver and a second driver spaced apart from the first driver. The first gate emission signal generator may include a plurality of first gate emission signal generators. The second gate emission signal generator may include a plurality of second gate emission signal generators. Each of the first driver and the second driver may include a corresponding first gate emission signal generator among the plurality of first gate emission signal generators and a corresponding second gate emission signal generator among the plurality of second gate emission signal generators. The first driving signal of the first driver may be the emission signal, and the second driving signal of the first driver may be a gate signal selected from a group consisting of the compensation gate signal, the initialization gate signal, and the bias gate signal. The first driving signal of the second driver may be different from the second driving signal of the first driver and may be a gate signal selected from the group consisting of the compensation gate signal, the initialization gate signal, and the bias gate signal. The second driving signal of the second driver may be a gate signal different from the second driving signal of the first driver and the first driving signal of the second driver.

An electronic device according to an embodiment of the disclosure includes: a display panel including a pixel; a driver which outputs a driving signal to the pixel; a controller which outputs a control signal to the driver; and a processor which outputs an input image data and an input signal to the controller. The driver includes: a first gate emission signal generator which generates a first driving signal; a second gate emission signal generator which generates a second driving signal different from the first driving signal and has a circuit structure substantially identical to a circuit structure of the first gate emission signal generator; a clock line which is disposed between the first gate emission signal generator and the second gate emission signal generator and outputs a clock signal; and a low voltage line which is disposed between the first gate emission signal generator and the second gate emission signal generator and outputs a first low gate voltage. The first gate emission signal generator is electrically connected to the clock line and the low voltage line. The second gate emission signal generator is electrically connected to the clock line and the low voltage line to which the first gate emission signal generator is electrically connected.

According to an aspect, there is provided a driver as set out in claim 1. Additional features are set out in claims 2 to 9. According to an aspect, there is provided a display device as set out in claim 10. Additional features are set out in claims 11 to 14. According to an aspect, there is provided an electronic device as set out in claim 15.

A driver according to an embodiment of the disclosure may include a first gate emission signal generator and a second gate emission signal generator that generate different kinds of driving signals, a clock line that is disposed between the first gate emission signal generator and the second gate emission signal generator, and outputs a clock signal, and a low voltage line that is disposed between the first gate emission signal generator and the second gate emission signal generator, and outputs a first low gate voltage.

The first gate emission signal generator and the second gate emission signal generator may share a same clock line. The first gate emission signal generator and the second gate emission signal generator may share a same low voltage line. Accordingly, the integration of the driver may be improved (e.g., decreased or reduced).

### BRIEF DESCRIPTION OF THE DRAWINGS

The above and other aspects, features, and advantages of certain embodiments will be more apparent from the following description taken in conjunction with the accompanying drawings, in which:
FIG. 1 is a schematic plan view illustrating a display device according to an embodiment of the disclosure;
FIG. 2 is a schematic block diagram illustrating the display device of FIG. 1;
FIG. 3A is a schematic diagram of an equivalent circuit illustrating an example of a circuit structure of a pixel included in the display device of FIG. 1;
FIG. 3B is a schematic diagram of an equivalent circuit illustrating another example of a circuit structure of a pixel included in the display device of FIG. 1;
FIG. 4 is a schematic cross-sectional view taken along line I-I' of FIG. 1;
FIG. 5 is a schematic block diagram illustrating an example of a gate emission driver of FIG. 2;
FIG. 6 is a schematic block diagram illustrating an example of a stage included in the gate emission driver of FIG. 5;
FIG. 7 is a schematic diagram of an equivalent circuit illustrating an example of a stage included in the gate emission driver of FIG. 5;
FIG. 8 is a schematic timing diagram illustrating an example of an operation of the stage of FIG. 7;
FIGS. 9 to 21 are schematic layout views illustrating an example of a stage included in the gate emission driver of FIG. 5;
FIG. 22 is a schematic block diagram illustrating another example of a gate emission driver of FIG. 2;
FIG. 23 is a schematic diagram of an equivalent circuit illustrating an example of a stage included in the gate emission driver of FIG. 22;
FIGS. 24, 25, 26, and 27 are schematic layout views illustrating an example of a stage included in the gate emission driver of FIG. 22;
FIG. 28 is a schematic block diagram illustrating an electronic device according to an embodiment of the disclosure; and
FIG. 29 is a schematic view illustrating an example in which the electronic device of FIG. 28 is implemented as a smartphone.

### DETAILED DESCRIPTION OF THE EMBODIMENTS

In the following description, for the purposes of explanation, numerous specific details are set forth in order to provide a thorough understanding of various embodiments or implementations of the disclosure. As used herein "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the disclosure. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the scope of the disclosure.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the axis of the first direction DR1, the axis of the second direction DR2, and the axis of the third direction DR3 are not limited to three axes of a rectangular coordinate system, such as the X, Y, and Z-axes, and may be interpreted in a broader sense. For example, the axis of the first direction DR1, the axis of the second direction DR2, and the axis of the third direction DR3 may be perpendicular to one another, or may represent different directions that are not perpendicular to one another. For the purposes of this disclosure, "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one element's relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein should be interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (e.g., microcode) to perform various functions discussed herein and may optionally be driven by firmware and/or software. It is also contemplated that each block, unit, and/or module may be implemented by dedicated hardware, or as a combination of dedicated hardware to perform some functions and a processor (e.g., one or more programmed microprocessors and associated circuitry) to perform other functions. Also, each block, unit, and/or module of some embodiments may be physically separated into two or more interacting and discrete blocks, units, and/or modules without departing from the scope of the disclosure. Further, the blocks, units, and/or modules of some embodiments may be physically combined into more complex blocks, units, and/or modules without departing from the scope of the disclosure.

The terms "about" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Unless otherwise defined or implied herein, all terms (including technical and scientific terms) used herein have the same meaning as commonly understood by those skilled in the art to which this disclosure pertains. It will be further understood that terms, such as those defined in commonly used dictionaries, should be interpreted as having a meaning that is consistent with their meaning in the context of the relevant art and the disclosure, and should not be interpreted in an ideal or excessively formal sense unless clearly so defined herein.

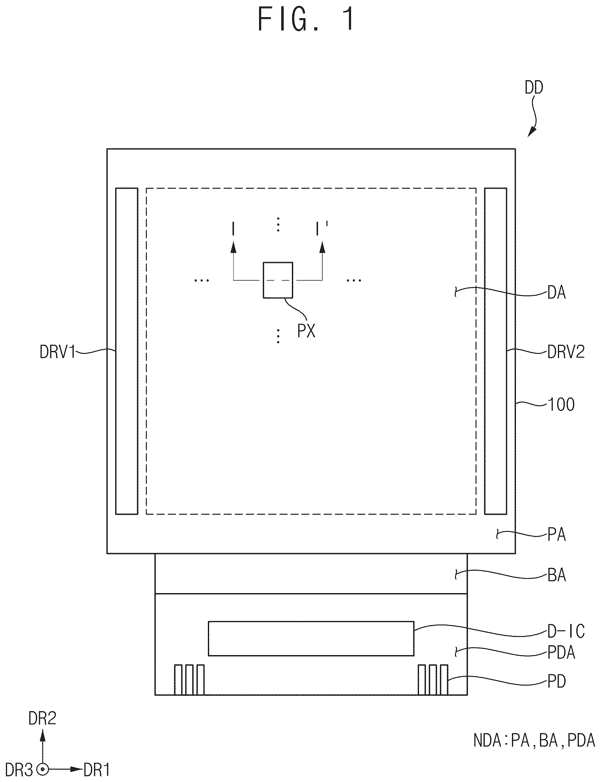

FIG. 1 is a schematic plan view illustrating a display device according to an embodiment of the disclosure.

In this specification, a plane may be defined by a first direction DR1 and a second direction DR2 intersecting the first direction DR1. For example, the first direction DR1 and the second direction DR2 may be perpendicular to each other. A direction (e.g., a thickness direction) normal to the plane (e.g., the plane formed by the first and second directions DR1 and DR2) of a display device DD may be a third direction DR3. For example, the third direction DR3 may be perpendicular to each of the first direction DR1 and the second direction DR2. As used herein the "plan view" is a view in the third direction DR3.

Referring to FIG. 1, the display device DD according to an embodiment of the disclosure may include a display panel 100, a driving chip D-IC, a first driver DRV1, and a second driver DRV2.

The display panel 100 may include a display area DA and a non-display area NDA. The display area DA may be defined as an area in which an image is displayed by generating light or adjusting the transmittance of light provided from an external light source. The display panel 100 may include pixels PX disposed (e.g., arranged) in the display area DA. Each of the pixels PX may generate light in response to a driving signal. For example, the pixels PX may be disposed (e.g., arranged) in a matrix form in the first direction DR1 and the second direction DR2.

The non-display area NDA may be adjacent to the display area DA. The non-display area NDA may be adjacent to (e.g., surround) at least a portion of the display area DA in a plan view. The non-display area NDA may be defined as an area in which an image is not displayed. The non-display area NDA may include a peripheral area PA, a bending area BA, and a pad area PDA.

The peripheral area PA may be positioned around the display area DA. The peripheral area PA may be adjacent to (e.g., surround) at least a portion of the display area DA in a plan view. For example, the peripheral area PA may surround (e.g., entirely surround) the display area DA in a plan view.

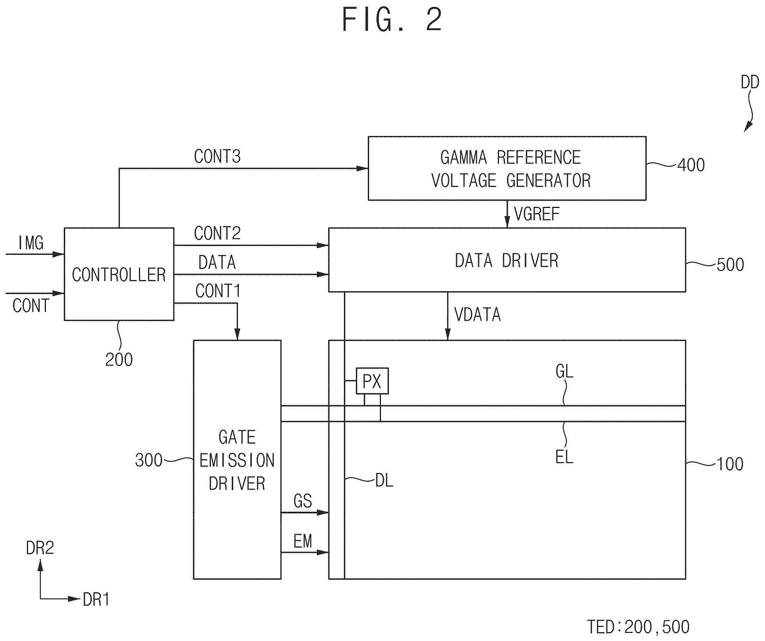

The first driver DRV1 and the second driver DRV2 may be disposed (e.g., arranged) in the peripheral area PA on the display panel 100. The first driver DRV1 and the second driver DRV2 may be spaced apart from each other. For example, the first driver DRV1 may be disposed (e.g., arranged) in the peripheral area PA adjacent to a left side of the display area DA, and the second driver DRV2 may be disposed (e.g., arranged) in the peripheral area PA adjacent to a right side of the display area DA. In an embodiment, each of the first driver DRV1 and the second driver DRV2 may correspond to a gate emission driver 300 of FIG. 2 described below. In an embodiment, one of the first driver DRV1 and the second driver DRV2 may be omitted.

The bending area BA may be positioned on a side of the display area DA. For example, the bending area BA may extend from a side of the peripheral area PA and may be bent in a downward direction. For example, the display panel 100 may be bent about a reference axis parallel to the first direction DR1 in the bending area BA. The pad area PDA may be positioned on a lower surface of the display device DD. In case that the display panel 100 is unfolded, the bending area BA may be positioned between the peripheral area PA and the pad area PDA.

The pad area PDA may be spaced apart from the display area DA. For example, the pad area PDA and the display area DA may be spaced apart from each other in the second direction DR2. For example, the pad area PDA may be spaced apart from the display area DA by the bending area BA in a plan view. The display panel 100 may further include pads PD disposed in the pad area PDA.

The driving chip D-IC may be disposed (e.g., arranged) in the pad area PDA on the display panel 100. The driving chip D-IC may be electrically connected to the pads PD through an anisotropic conductive film. The driving chip D-IC may provide the driving signal to the pixels PX. The driving signal may include various signals for driving the pixels PX, such as a driving voltage, a data voltage, or the like. The driving signal may be transmitted to the pixels PX through the driving chip D-IC and the pads PD. In an embodiment, the driving chip D-IC may correspond to a data driver 500 of FIG. 2.

Although not illustrated in FIG. 1, a printed circuit board may be disposed (e.g., arranged) in the pad area PDA on the display panel 100. The printed circuit board may be electrically connected to the pads PD through an anisotropic conductive film. For example, the printed circuit board may be a flexible printed circuit board.

FIG. 2 is a schematic block diagram illustrating the display device of FIG. 1.

Referring to FIG. 2, the display device DD may include the display panel 100 and a panel driver for driving the display panel 100. The panel driver may include a controller 200, a gate emission driver 300, a gamma reference voltage generator 400, and a data driver 500.

For example, the controller 200 and the data driver 500 may be integral with each other. A driving module in which the controller 200 and the data driver 500 are integral with each other may be referred to as a timing controller embedded data driver TED.

The display panel 100 may include gate lines GL, data lines DL, emission lines EL, and the pixels PX. The pixels PX may be electrically connected to the gate lines GL, the data lines DL, and the emission lines EL. Each of the pixels PX may generate light in response to a driving signal. For example, each of the gate lines GL may extend in the first direction DR1. Each of the emission lines EL may extend in the first direction DR1. Each of the data lines DL may extend in the second direction DR2.

The controller 200 may receive an input image data IMG and an input signal CONT from an external device. For example, the input image data IMG may include red image data, green image data, and blue image data. The input image data IMG may further include white image data. The input signal CONT may include a vertical synchronization signal, a horizontal synchronization signal, a data enable signal, a master clock signal, or the like.

The controller 200 may generate a first control signal CONT1, a second control signal CONT2, a third control signal CONT3, and a data signal DATA based on the input image data IMG and the input signal CONT. The controller 200 may output the first control signal CONT1 to the gate emission driver 300. The first control signal CONT1 may include a vertical start signal and a clock signal. The controller 200 may output the second control signal CONT2 and the data signal DATA to the data driver 500. The second control signal CONT2 may include a horizontal start signal and a load signal. The controller 200 may output the third control signal CONT3 to the gamma reference voltage generator 400.

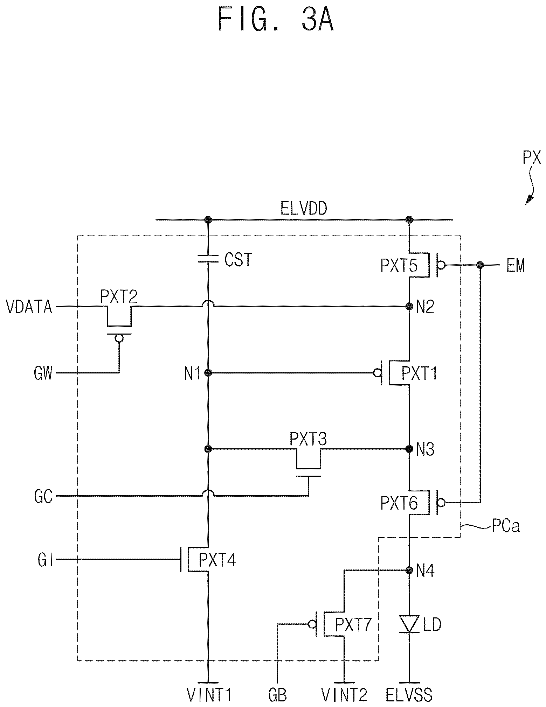

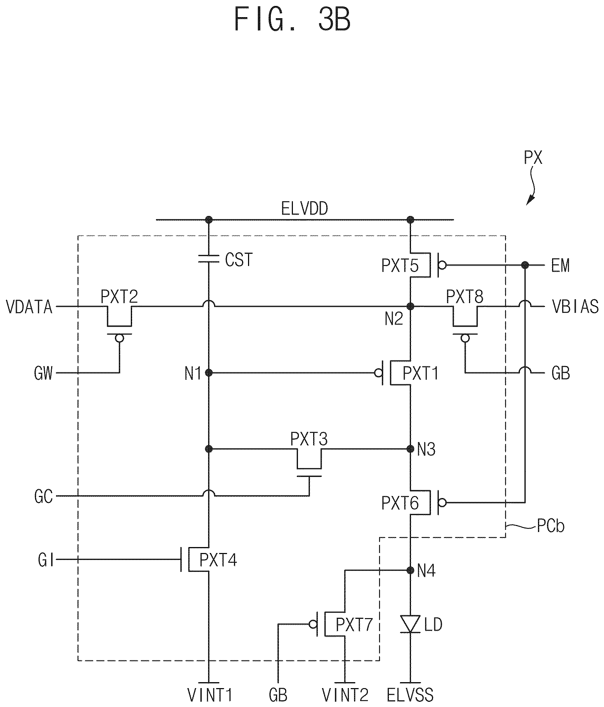

The gate emission driver 300 may generate gate signals GS and emission signals EM in response to the first control signal CONT1. The gate emission driver 300 may output the gate signals GS to the gate lines GL. The gate emission driver 300 may output the emission signals EM to the emission lines EL. In an embodiment, the gate signals GS may include a write gate signal GW, a compensation gate signal GC, an initialization gate signal GI, and a bias gate signal GB illustrated in FIGS. 3A and 3B. However, embodiments of the disclosure are not limited thereto.

In an embodiment, the gate emission driver 300 may be disposed (e.g., arranged) in the peripheral area PA (e.g., refer to FIG. 1) on the display panel 100. For example, the gate emission driver 300 may be disposed (e.g., mounted) on the display panel 100 in the peripheral area. The gate emission driver 300 may correspond to the first driver DRV1 and the second driver DRV2 of FIG. 1.

The gamma reference voltage generator 400 may generate a gamma reference voltage VGREF in response to the third control signal CONT3. The gamma reference voltage generator 400 may provide the gamma reference voltage VGREF to the data driver 500. For example, the gamma reference voltage generator 400 may be disposed (e.g., arranged) in the controller 200 or in the data driver 500.

The data driver 500 may receive the second control signal CONT2 and the data signal DATA from the controller 200, and may receive the gamma reference voltage VGREF from the gamma reference voltage generator 400. The data driver 500 may convert the data signal DATA into an analog form of a data voltage VDATA using the gamma reference voltage VGREF. The data driver 500 may output the data voltage VDATA to the data lines DL.

In an embodiment, the data driver 500 may be disposed (e.g., arranged) in the pad area PDA (e.g., refer to FIG. 1) on the display panel 100. For example, the data driver 500 may be disposed (e.g., mounted) on the display panel 100 in the pad area PDA. The data driver 500 may correspond to the driving chip D-IC of FIG. 1.

FIG. 3A is a schematic diagram of an equivalent circuit illustrating an example of a circuit structure of a pixel included in the display device of FIG. 1.

Referring to FIG. 3A, each of the pixels PX may include a light-emitting element LD and a pixel driving circuit PCa electrically connected to the light-emitting element LD. In an embodiment, the pixel driving circuit PCa may include first to seventh pixel transistors PXT1, PXT2, PXT3, PXT4, PXT5, PXT6, and PXT7 and a storage capacitor CST. In FIG. 3A, the first pixel transistor PXT1, the second pixel transistor PXT2, the fifth pixel transistor PXT5, the sixth pixel transistor PXT6, and the seventh pixel transistor PXT7 may be p-type transistors, and the third pixel transistor PXT3 and the fourth pixel transistor PXT4 may be n-type transistors. However, embodiments of the disclosure are not limited thereto, and all of the first to seventh pixel transistors PXT1, PXT2, PXT3, PXT4, PXT5, PXT6, and PXT7 may be p-type transistors.

The first pixel transistor PXT1 may include a gate electrode, a first electrode, and a second electrode. The gate electrode of the first pixel transistor PXT1 may be electrically connected to a first node N1. The first electrode of the first pixel transistor PXT1 may be electrically connected to a second node N2. The first electrode of the first pixel transistor PXT1 may receive a driving voltage ELVDD. The second electrode of the first pixel transistor PXT1 may be electrically connected to a third node N3. The first pixel transistor PXT1 may provide a driving current to the light-emitting element LD.

The second pixel transistor PXT2 may include a gate electrode, a first electrode, and a second electrode. The gate electrode of the second pixel transistor PXT2 may receive a write gate signal GW. The first electrode of the second pixel transistor PXT2 may receive the data voltage VDATA. The second electrode of the second pixel transistor PXT2 may be electrically connected to the second node N2.

The second pixel transistor PXT2 may be turned on or turned off in response to the write gate signal GW. In case that the second pixel transistor PXT2 is turned on, the second electrode of the second pixel transistor PXT2 may provide the data voltage VDATA to the second node N2.

The third pixel transistor PXT3 may include a gate electrode, a first electrode, and a second electrode. The gate electrode of the third pixel transistor PXT3 may receive a compensation gate signal GC. The first electrode of the third pixel transistor PXT3 may be electrically connected to the first node N1. The second electrode of the third pixel transistor PXT3 may be electrically connected to the third node N3.

The third pixel transistor PXT3 may be turned on or turned off in response to the compensation gate signal GC. In case that the third pixel transistor PXT3 is turned on, the third pixel transistor PXT3 may diode-connect the first pixel transistor PXT1. For example, the third pixel transistor PXT3 may form a path for compensating a threshold voltage of the first pixel transistor PXT1.

The fourth pixel transistor PXT4 may include a gate electrode, a first electrode, and a second electrode. The gate electrode of the fourth pixel transistor PXT4 may receive an initialization gate signal GI. The first electrode of the fourth pixel transistor PXT4 may be electrically connected to the first node N1. The second electrode of the fourth pixel transistor PXT4 may receive a first initialization voltage VINT1.

The fourth pixel transistor PXT4 may be turned on or turned off in response to the initialization gate signal GI. In case that the fourth pixel transistor PXT4 is turned on, the fourth pixel transistor PXT4 may provide the first initialization voltage VINT1 to the first node N1. Accordingly, the fourth pixel transistor PXT4 may provide the first initialization voltage VINT 1 to the gate electrode of the first pixel transistor PXT1 and initialize a voltage of the gate electrode of the first pixel transistor PXT1.

The fifth pixel transistor PXT5 may include a gate electrode, a first electrode, and a second electrode. The gate electrode of the fifth pixel transistor PXT5 may receive an emission signal EM. The first electrode of the fifth pixel transistor PXT5 may receive the driving voltage ELVDD. The second electrode of the fifth pixel transistor PXT5 may be electrically connected to the second node N2.

The fifth pixel transistor PXT5 may be turned on or turned off in response to the emission signal EM. In case that the fifth pixel transistor PXT5 is turned on, the fifth pixel transistor PXT5 may provide the driving voltage ELVDD to the second node N2.

The sixth pixel transistor PXT6 may include a gate electrode, a first electrode, and a second electrode. The gate electrode of the sixth pixel transistor PXT6 may receive the emission signal EM. The first electrode of the sixth pixel transistor PXT6 may be electrically connected to the third node N3. The second electrode of the sixth pixel transistor PXT6 may be electrically connected to a fourth node N4.

The sixth pixel transistor PXT6 may be turned on or turned off in response to the emission signal EM. In case that the sixth pixel transistor PXT6 is turned on, the sixth pixel transistor PXT6 may electrically connect the second electrode of the first pixel transistor PXT1 and an anode of the light-emitting element LD. Accordingly, the sixth pixel transistor PXT6 may provide the driving current to the light-emitting element LD.

In FIG. 3A, the fifth pixel transistor PXT5 and the sixth pixel transistor PXT6 may be simultaneously driven by the substantially single emission signal EM. However, embodiments of the disclosure are not limited thereto. For example, the fifth pixel transistor PXT5 and the sixth pixel transistor PXT6 may be independently driven by different emission control signals.

The seventh pixel transistor PXT7 may include a gate electrode, a first electrode, and a second electrode. The gate electrode of the seventh pixel transistor PXT7 may receive a bias gate signal GB. The first electrode of the seventh pixel transistor PXT7 may be electrically connected to the fourth node N4. The second electrode of the seventh pixel transistor PXT7 may receive a second initialization voltage VINT2.

The seventh pixel transistor PXT7 may be turned on or turned off in response to the bias gate signal GB. In case that the seventh pixel transistor PXT7 is turned on, the seventh pixel transistor PXT7 may provide the second initialization voltage VINT2 to the fourth node N4. Accordingly, the seventh pixel transistor PXT7 may provide the second initialization voltage VINT2 to the anode of the light-emitting element LD and initialize a voltage of the anode.

The storage capacitor CST may include a first electrode and a second electrode. The first electrode of the storage capacitor CST may receive the driving voltage ELVDD. The second electrode of the storage capacitor CST may be electrically connected to the first node N1.

The light-emitting element LD may include the anode and a cathode. The anode of the light-emitting element LD may be electrically connected to the fourth node N4. The cathode of the light-emitting element LD may receive a common voltage ELVSS. The light-emitting element LD may generate light having a luminance corresponding to the driving current.

FIG. 3B is a schematic diagram of an equivalent circuit illustrating another example of a circuit structure of a pixel included in the display device of FIG. 1.

The circuit structure of the pixel PX described above with reference to FIG. 3A is different from the circuit structure of the pixel PX described below with reference to FIG. 3B at least in that a pixel driving circuit PCb further includes an eighth pixel transistor PXT8. Accordingly, detailed description of the same or similar constituent elements is omitted (or summarized).

Referring to FIG. 3B, each of the pixels PX may include a light-emitting element LD and the pixel driving circuit PCb electrically connected to the light-emitting element LD. In an embodiment, the pixel driving circuit PCb may include first to eighth pixel transistors PXT1, PXT2, PXT3, PXT4, PXT5, PXT6, PXT7, and PXT8 and a storage capacitor CST. In FIG. 3B, the first pixel transistor PXT1, the second pixel transistor PXT2, the fifth pixel transistor PXT5, the sixth pixel transistor PXT6, the seventh pixel transistor PXT7, and the eighth pixel transistor PXT8 may be p-type transistors, and the third pixel transistor PXT3 and the fourth pixel transistor PXT4 may be n-type transistors. However, embodiments of the disclosure are not limited thereto, and all of the first to eighth pixel transistors PXT1, PXT2, PXT3, PXT4, PXT5, PXT6, PXT7, and PXT8 may be p-type transistors.

The eighth pixel transistor PXT8 may include a gate electrode, a first electrode, and a second electrode. The gate electrode of the eighth pixel transistor PXT8 may receive a bias gate signal GB. The first electrode of the eighth pixel transistor PXT8 may receive a bias voltage VBIAS. The second electrode of the eight pixel transistor PXT8 may be electrically connected to a second node N2.

The eighth pixel transistor PXT8 may be turned on or turned off in response to the bias gate signal GB. In case that the eighth pixel transistor PXT8 is turned on, the second electrode of the eighth pixel transistor PXT8 may provide the bias voltage VBIAS to a first electrode of the first pixel transistor PXT1.

In an embodiment, the seventh pixel transistor PXT7 and the eighth pixel transistor PXT8 may be simultaneously driven by the same bias gate signal GB, but the embodiments of the disclosure are not limited thereto. For example, the seventh pixel transistor PXT7 and the eighth pixel transistor PXT8 may be independently driven by different bias gate signals.

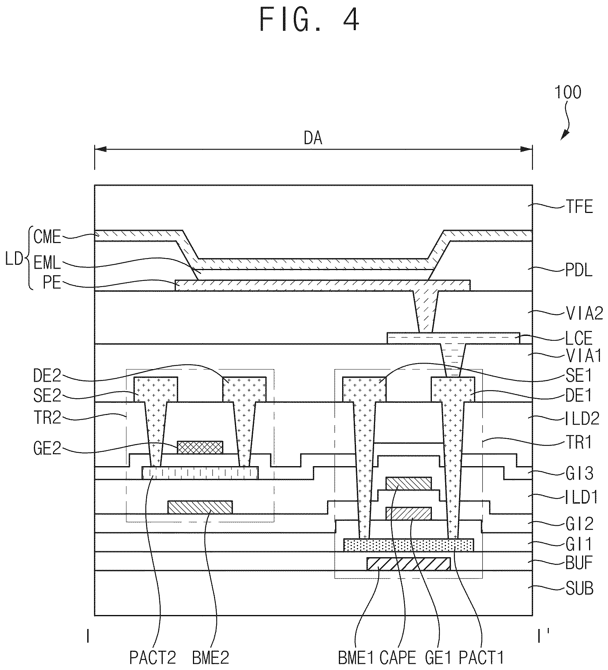

FIG. 4 is a schematic cross-sectional view taken along line I-I' of FIG. 1.

Referring to FIG. 4, the display panel 100 may include a substrate SUB, a buffer layer BUF, a first thin film transistor TR1, a first gate insulating layer GI1, a second gate insulating layer GI2, a capacitor electrode CAPE, a second thin film transistor TR2, a first inter-layer insulating layer ILD1, a second inter-layer insulating layer ILD2, a first via-insulating layer VIA1, a connection electrode LCE, a second via-insulating layer VIA2, the light-emitting element LD, a pixel defining layer PDL, and an encapsulation layer TFE.

The first thin film transistor TR1 may include a first lower electrode BME1, a first pixel active pattern PACT1, a first pixel gate electrode GE1, a first pixel output electrode SE1, and a second pixel output electrode DE1. The second thin film transistor TR2 may include a second lower electrode BME2, a second pixel active pattern PACT2, a second pixel gate electrode GE2, a third pixel output electrode SE2, and a fourth pixel output electrode DE2. The light-emitting element LD may include a pixel electrode PE, a light-emitting layer EML, and a common electrode CME.

The first thin film transistor TR1 of FIG. 4 may be a transistor electrically connected to the light-emitting element LD through the connection electrode LCE. For example, the first thin film transistor TR1 may be the sixth pixel transistor PXT6 of FIGS. 3A and 3B, and the second thin film transistor TR2 may be any one of the third pixel transistor PXT3 and fourth pixel transistor PXT4 of FIGS. 3A and 3B.

The substrate SUB may include a transparent material or an opaque material. The substrate SUB may be formed of a transparent resin substrate. A polyimide substrate may be an example of the transparent resin substrate of the substrate SUB. The polyimide substrate of the substrate SUB may include a first organic layer, a first barrier layer, a second organic layer, or the like. In an embodiment, the substrate SUB may include a quartz substrate (e.g., a synthetic quartz substrate, a fluorine-doped quartz substrate, or the like), a calcium fluoride substrate, a soda-lime glass substrate, a non-alkali glass substrate, or the like. These may be used alone or in combination with each other. However, embodiments of the disclosure are not limited thereto.

The first lower electrode BME1 may be disposed (e.g., arranged) on the substrate SUB. The first lower electrode BME1 may overlap the first pixel active pattern PACT1 in a plan view. The first lower electrode BME1 may function as (or be implemented with) a lower gate electrode of the first thin film transistor TR1. The first lower electrode BME1 may include at least one conductive material of a metal, an alloy, a conductive metal nitride, a conductive metal oxide, and a transparent conductive oxide. However, embodiments of the disclosure are not limited thereto. Examples of the conductive material that may be used as the first lower electrode BME1 may include at least one of silver (Ag), an alloy including silver, molybdenum (Mo), an alloy including molybdenum, aluminum (Al), an alloy including aluminum, aluminum nitride (AlN), tungsten (W), tungsten nitride (WN), copper (Cu), nickel (Ni), chromium (Cr), chromium nitride (CrN), titanium (Ti), tantalum (Ta), platinum (Pt), scandium (Sc), indium tin oxide (ITO), and indium zinc oxide (IZO). These may be used alone or in combination with each other. However, embodiments of the disclosure are not limited thereto.

The buffer layer BUF may be disposed (e.g., arranged) on the substrate SUB. The buffer layer BUF may cover the first lower electrode BME1. The buffer layer BUF may prevent diffusion of metal atoms or impurities from the substrate SUB to an upper structure (or elements disposed above the buffer layer BUF). The buffer layer BUF may improve the flatness of a surface of the substrate SUB in case that the surface of the substrate SUB is not uniform. For example, the buffer layer BUF may planarize the surface of the substrate SUB. The buffer layer BUF may include an inorganic insulating material. Examples of the inorganic insulating material that may be used as the buffer layer BUF may include at least one of silicon oxide (SiOₓ), silicon nitride (SiNₓ), and silicon oxynitride (SiOₓN_{y}). These may be used alone or in combination with each other. However, embodiments of the disclosure are not limited thereto. In an embodiment, the buffer layer BUF may be omitted.

The first pixel active pattern PACT1 may be disposed (e.g., arranged) on the substrate SUB. For example, the first pixel active pattern PACT1 may be disposed (e.g., arranged) on the buffer layer BUF. The first pixel active pattern PACT1 may include a semiconductor material. In an embodiment, the first pixel active pattern PACT1 may include a silicon semiconductor material. The silicon semiconductor material of the first pixel active pattern PACT1 may include amorphous silicon, polycrystalline silicon, or the like.

The first gate insulating layer GI1 may be disposed (e.g., arranged) on the buffer layer BUF. The first gate insulating layer GI1 may cover the first pixel active pattern PACT1. The first gate insulating layer GI1 may include an inorganic insulating material.

The first pixel gate electrode GE1 may be disposed (e.g., arranged) on the first gate insulating layer GI1. The first pixel gate electrode GE1 may overlap the first pixel active pattern PACT1 in a plan view. The first pixel gate electrode GE1 may function as (or be implemented with) an upper gate electrode of the first thin film transistor TR1. The first pixel gate electrode GE1 may include at least one conductive material of a metal, an alloy, a conductive metal nitride, a conductive metal oxide, and a transparent conductive oxide. These may be used alone or in combination with each other. However, embodiments of the disclosure are not limited thereto.

The second gate insulating layer GI2 may be disposed (e.g., arranged) on the first gate insulating layer GI1. The second gate insulating layer GI2 may cover the first pixel gate electrode GE1. The second gate insulating layer GI2 may include an inorganic insulating material.

The capacitor electrode CAPE may be disposed (e.g., arranged) on the second gate insulating layer GI2. The capacitor electrode CAPE may overlap the first pixel gate electrode GE1 in a plan view. The capacitor electrode CAPE and the first pixel gate electrode GE1 may form the storage capacitor CST of FIGS. 3A and 3B. The capacitor electrode CAPE may include at least one conductive material of a metal, an alloy, a conductive metal nitride, a conductive metal oxide, and a transparent conductive oxide. These may be used alone or in combination with each other. However, embodiments of the disclosure are not limited thereto.

The second lower electrode BME2 may be disposed (e.g., arranged) on the second gate insulating layer GI2. The second lower electrode BME2 may overlap the second pixel active pattern PACT2 in a plan view. The second lower electrode BME2 may function as (or be implemented with) a lower gate electrode of the second thin film transistor TR2. The second lower electrode BME2 may include at least one conductive material of a metal, an alloy, a conductive metal nitride, a conductive metal oxide, and a transparent conductive oxide. These may be used alone or in combination with each other. However, embodiments of the disclosure are not limited thereto.

The first inter-layer insulating layer ILD1 may be disposed (e.g., arranged) on the second gate insulating layer GI2. The first inter-layer insulating layer ILD1 may cover the capacitor electrode CAPE and the second lower electrode BME2. The first inter-layer insulating layer ILD1 may include an inorganic insulating material.

The second pixel active pattern PACT2 may be disposed (e.g., arranged) on the first inter-layer insulating layer ILD1. The second pixel active pattern PACT2 may include a semiconductor material. In an embodiment, the second pixel active pattern PACT2 may include an oxide semiconductor material. The oxide semiconductor material of the second pixel active pattern PACT2 may include at least one oxide of indium (In), gallium (Ga), tin (Sn), zirconium (Zr), vanadium (V), hafnium (Hf), cadmium (Cd), germanium (Ge), chromium (Cr), titanium (Ti), and zinc (Zn). However, embodiments of the disclosure are not limited thereto.

The third gate insulating layer GI3 may be disposed (e.g., arranged) on the first inter-layer insulating layer ILD1. The third gate insulating layer GI3 may cover the second pixel active pattern PACT2. The third gate insulating layer GI3 may include an inorganic insulating material.

The second pixel gate electrode GE2 may be disposed (e.g., arranged on the third gate insulating layer GI3. The second pixel gate electrode GE2 may overlap the second pixel active pattern PACT2 in a plan view. The second pixel gate electrode GE2 may function as (or be implemented with) an upper gate electrode of the second thin film transistor TR2. The second pixel gate electrode GE2 may include at least one conductive material of a metal, an alloy, a conductive metal nitride, a conductive metal oxide, and a transparent conductive oxide. These may be used alone or in combination with each other. However, embodiments of the disclosure are not limited thereto.

The second inter-layer insulating layer ILD2 may be disposed (e.g., arranged) on the third gate insulating layer GI3. The second inter-layer insulating layer ILD2 may cover the second pixel gate electrode GE2. The second inter-layer insulating layer ILD2 may include an inorganic insulating material.

The first pixel output electrode SE1 and the second pixel output electrode DE1 may be disposed (e.g., arranged) on the second inter-layer insulating layer ILD2. The first pixel output electrode SE1 may be electrically connected to the first pixel active pattern PACT1 through a contact hole penetrating the first gate insulating layer GI1, the second gate insulating layer GI2, the first inter-layer insulating layer ILD1, the third gate insulating layer GI3, and the second inter-layer insulating layer ILD2. The second pixel output electrode DE1 may be electrically connected to the first pixel active pattern PACT1 through a contact hole penetrating the first gate insulating layer GI1, the second gate insulating layer GI2, the first inter-layer insulating layer ILD1, the third gate insulating layer GI3, and the second inter-layer insulating layer ILD2.

Accordingly, the first thin film transistor TR1 including the first lower electrode BME1, the first pixel active pattern PACT1, the first pixel gate electrode GE1, the first pixel output electrode SE1, and the second pixel output electrode DE1 may be formed on the substrate SUB.

The third pixel output electrode SE2 and the fourth pixel output electrode DE2 may be disposed (e.g., arranged) on the second inter-layer insulating layer ILD2. The third pixel output electrode SE2 may be electrically connected to the second pixel active pattern PACT2 through a contact hole penetrating the third gate insulating layer GI3 and the second inter-layer insulating layer ILD2. The fourth pixel output electrode DE2 may be electrically connected to the second pixel active pattern PACT2 through a contact hole penetrating the third gate insulating layer GI3 and the second inter-layer insulating layer ILD2.

Accordingly, the second thin film transistor TR2 including the second lower electrode BME2, the second pixel active pattern PACT2, the second pixel gate electrode GE2, the third pixel output electrode SE2, and the fourth pixel output electrode DE2 may be formed on the second gate insulating layer GI2.

The first via-insulating layer VIA1 may be disposed (e.g., arranged) on the second inter-layer insulating layer ILD2. The first via-insulating layer VIA1 may cover the first to fourth pixel output electrodes SE1, DE1, SE2, and DE2. The first via-insulating layer VIA1 may include an organic insulating material. Examples of the organic insulating material that may be used as the first via-insulating layer VIA1 may include at least one of a polyacryl-based resin, a polyimide-based resin, a polyamide-based resin, a siloxane-based resin, an acryl-based resin, and an epoxy-based resin. These may be used alone or in combination with each other. However, embodiments of the disclosure are not limited thereto.

The connection electrode LCE may be disposed (e.g., arranged) on the first via-insulating layer VIA1. The connection electrode LCE may be electrically connected to the first pixel output electrode SE1 or the second pixel output electrode DE1 through a contact hole penetrating the first via-insulating layer VIA1. Accordingly, the connection electrode LCE may electrically connect the first thin film transistor TR1 and the light-emitting element LD. The connection electrode LCE may include at least one conductive material of a metal, an alloy, a conductive metal nitride, a conductive metal oxide, and a transparent conductive oxide. These may be used alone or in combination with each other. However, embodiments of the disclosure are not limited thereto.

The second via-insulating layer VIA2 may be disposed (e.g., arranged) on the first via-insulating layer VIA1. The second via-insulating layer VIA2 may cover the connection electrode LCE. The second via-insulating layer VIA2 may include an organic insulating material.

The pixel electrode PE may be disposed (e.g., arranged) on the second via-insulating layer VIA2. The pixel electrode PE may be electrically connected to the connection electrode LCE through a contact hole penetrating the second via-insulating layer VIA2. The pixel electrode PE may include at least one conductive material of a metal, an alloy, a conductive metal nitride, a conductive metal oxide, and a transparent conductive oxide. These may be used alone or in combination with each other. However, embodiments of the disclosure are not limited thereto. For example, the pixel electrode PE may function as (or be implemented with) an anode of the light-emitting element LD.

The pixel defining layer PDL may be disposed (e.g., arranged) on the second via-insulating layer VIA2. The pixel defining layer PDL may cover an edge of the pixel electrode PE, and may expose an upper surface of the pixel electrode PE. The pixel defining layer PDL may include an organic insulating material and/or an inorganic insulating material.

The light-emitting layer EML may be disposed (e.g., arranged) on the pixel electrode PE. The light-emitting layer EML may emit light having a color (e.g., a specific or selectable color such as red, green, or blue). In an embodiment, the light-emitting layer EML may include at least one of an organic light-emitting material and a quantum dot. For example, the light-emitting layer EML may have a single-layer structure including a light-emitting structure. However, embodiments of the disclosure are not limited thereto, and the light-emitting layer EML may have a tandem structure including light-emitting structures.

The common electrode CME may be disposed (e.g., arranged) on the pixel defining layer PDL and the light-emitting layer EML. The common electrode CME may cover the pixel defining layer PDL and the light-emitting layer EML, and may be disposed (e.g., arranged) along the profiles of the pixel defining layer PDL and the light-emitting layer EML with a substantially uniform thickness. The common electrode CME may include at least one conductive material of a metal, alloy, conductive metal nitride, conductive metal oxide, and transparent conductive oxide. These may be used alone or in combination with each other. However, embodiments of the disclosure are not limited thereto. For example, the common electrode CME may function as (or be implemented with) a cathode of the light-emitting element LD.

Accordingly, the light-emitting element LD including the pixel electrode PE, the light-emitting layer EML, and the common electrode CME may be formed on the second via-insulating layer VIA2.

The encapsulation layer TFE may be disposed (e.g., arranged) on the common electrode CME. The encapsulation layer TFE may prevent impurities, moisture, or the like from penetrating the light-emitting element LD from the outside. The encapsulation layer TFE may include at least one inorganic encapsulation layer and at least one organic encapsulation layer. For example, the inorganic encapsulation layer of the encapsulation layer TFE may include at least one of silicon oxide (SiOₓ), silicon nitride (SiNₓ), and silicon oxynitride (SiOₓN_{y}). These may be used alone or in combination with each other. However, embodiments of the disclosure are not limited thereto. For example, the organic encapsulation layer may include a polymer cured material such as polyacrylate.

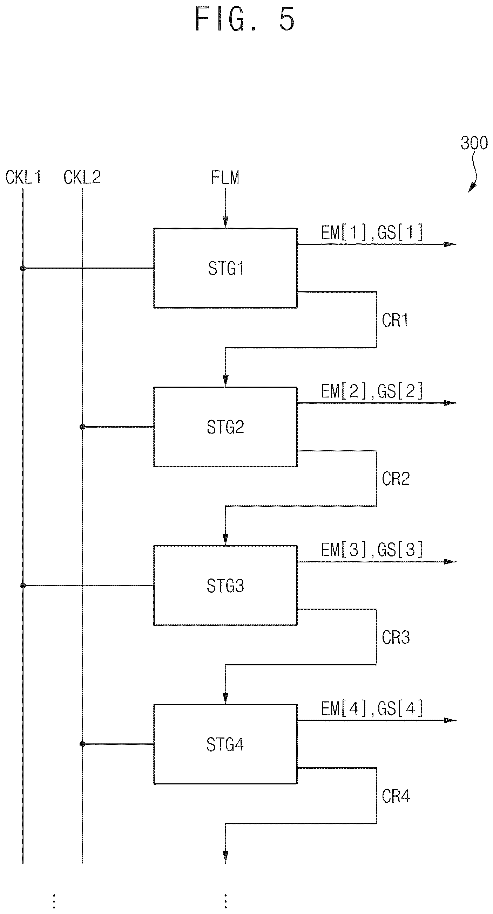

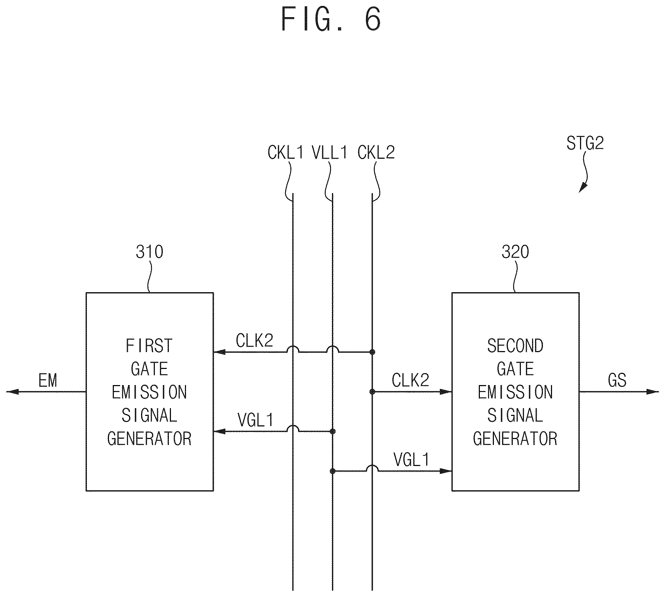

FIG. 5 is a schematic block diagram illustrating an example of a gate emission driver of FIG. 2. FIG. 6 is a schematic block diagram illustrating an example of a stage included in the gate emission driver of FIG. 5.

Referring to FIGS. 5 and 6, the gate emission driver 300 may include stages STG1, STG2, STG3, STG4, ..., a first clock line CKL1, a second clock line CKL2, and a first low voltage line VLL1.

The stages STG1, STG2, STG3, STG4, ... may be disposed (e.g., arranged) in a column direction (e.g., the second direction DR2). For example, a first stage STG1 may be positioned at a first row and may generate driving signals to output to the pixels PX (e.g., refer to FIG. 2) disposed (e.g., arranged) at the first row. A second stage STG2 may be positioned at a second row, and may generate driving signals to output to the pixels disposed (e.g., arranged) at the second row. A third stage STG3 may be positioned at a third row, and may generate driving signals to output to the pixels disposed (e.g., arranged) at the third row. A fourth stage STG4 may be positioned at a fourth row, and may generate driving signals to output to the pixels disposed (e.g., arranged) at the fourth row.

Each of the first clock line CKL1 and the second clock line CKL2 may extend in the second direction DR2. The first clock line CKL1 may output a first clock signal, and the second clock line CKL2 may output a second clock signal CLK2. In an embodiment, the stages positioned at odd-numbered rows may be electrically connected to the first clock line CKL1, and the stages positioned at even-numbered rows may be electrically connected to the second clock line CKL2. For example, the first stage STG1 and the third stage STG3 may be electrically connected to the first clock line CKL1, and the second stage STG2 and the fourth stage STG4 may be electrically connected to the second clock line CKL2.

The first low voltage line VLL1 may extend in the second direction DR2. The first low voltage line VLL1 may be electrically connected to each of the stages STG1, STG2, STG3, STG4, .... The first low voltage line VLL1 may output a first low gate voltage VGL1.

The first stage STG1 may receive a vertical start signal FLM as an input signal, and subsequent stages STG2, STG3, STG4, ... may receive carry signals CR1, CR2, CR3, CR4, ... of the respective previous stages as input signals. For example, the second stage STG2 may receive a first carry signal CR1, the third stage STG3 may receive a second carry signal CR2, and the fourth stage STG4 may receive a third carry signal CR3.

In an embodiment, each of the stages STG1, STG2, STG3, STG4, ... may generate two different kinds of driving signals among the emission signal EM, the bias gate signal GB, the compensation gate signal GC, and the initialization gate signal GI described above with reference to FIGS. 3A and 3B.

In an embodiment of FIG. 5, each of the stages STG1, STG2, STG3, STG4, ... may generate any one of emission signals EM[1], EM[2], EM[3], EM[4], ... and any one of gate signals GS[1], GS[2], GS[3], GS[4], .... For example, the first stage STG1 may generate the first carry signal CR1, a first emission signal EM[1], and a first gate signal GS[1] based on the vertical start signal FLM. Each of the first emission signal EM[1] and the first gate signal GS[1] may be applied to the pixels disposed (e.g., arranged) at the first row. The second stage STG2 may generate the second carry signal CR2, a second emission signal EM[2], and a second gate signal GS[2] based on the first carry signal CR1. Each of the second emission signal EM[2] and the second gate signal GS[2] may be applied to the pixels disposed (e.g., arranged) at the second row. The third stage STG3 may generate the third carry signal CR3, a third emission signal EM[3], and a third gate signal GS[3] based on the second carry signal CR2. Each of the third emission signal EM[3] and the third gate signal GS[3] may be applied to the pixels disposed (e.g., arranged) at the third row. The fourth stage STG4 may generate a fourth carry signal CR4, a fourth emission signal EM[4], and a fourth gate signal GS[4] based on the third carry signal CR3. Each of the fourth emission signal EM[4] and the fourth gate signal GS[4] may be applied to the pixels disposed (e.g., arranged) at the fourth row.

In an embodiment, the emission signals EM[1], EM[2], EM[3], EM[4], ... may correspond to the emission signal EM described above with reference to FIGS. 3A and 3B, and the gate signals GS[1], GS[2], GS[3], GS[4], ... may correspond to the bias gate signal GB described above with reference to FIGS. 3A and 3B. However, embodiments of the disclosure are not limited thereto, and the gate signals GS[1], GS[2], GS[3], GS[4], ... may be any of the compensation gate signal GC and the initialization gate signal GI described above with reference to FIGS. 3A and 3B.

In an embodiment, each of the stages STG1, STG2, STG3, STG4, ... may generate two different kinds of gate signals. For example, each of the stages STG1, STG2, STG3, STG4, ... may generate the compensation gate signal GC and the initialization gate signal GI described above with reference to FIGS. 3A and 3B. However, embodiments of the disclosure are not limited thereto.

Each of the stages STG1, STG2, STG3, STG4, ... may have a same circuit structure (or substantially the same circuit structure) as each other. Therefore, hereinafter, the second stage STG2 may be described below, and detailed description the same or similar constituent elements of other stages STG1, STG3, STG4, ... is omitted. Hereinafter, for convenience of description, the second emission signal EM[2] may be referred to as an emission signal EM and the second gate signal GS[2] may be referred to as a gate signal GS.

In FIG. 6, the second stage STG2 may include a first gate emission signal generator 310 and a second gate emission signal generator 320.

The first gate emission signal generator 310 may be electrically connected to the second clock line CKL2 and the first low voltage line VLL1. The first gate emission signal generator 310 may receive the second clock signal CLK2 through the second clock line CKL2, and may receive the first low gate voltage VGL1 through the first low voltage line VLL1.

The second gate emission signal generator 320 may be electrically connected to the second clock line CKL2 and the first low voltage line VLL1. For example, the second gate emission signal generator 320 may be electrically connected to the second clock line CKL2 and the first low voltage line VLL1 to which the first gate emission signal generator 310 is electrically connected. The second gate emission signal generator 320 may receive the second clock signal CLK2 through the second clock line CKL2, and may receive the first low gate voltage VGL1 through the first low voltage line VLL1.

In an embodiment, the first gate emission signal generator 310 may generate a first driving signal of any one of the emission signal EM, the bias gate signal GB, the compensation gate signal GC, and the initialization gate signal GI described above with reference to FIGS. 3A and 3B. The second gate emission signal generator 320 may generate a second driving signal, which is different from the first driving signal, of any one of the emission signal EM, the bias gate signal GB, the compensation gate signal GC, and the initialization gate signal GI described above with reference to FIGS. 3A and 3B.

In an embodiment, the first gate emission signal generator 310 may generate the emission signal EM based on the second clock signal CLK2 and the first low gate voltage VGL1, and the second gate emission signal generator 320 may generate the gate signal GS based on the second clock signal CLK2 and the first low gate voltage VGL1. The gate signal GS may correspond to the bias gate signal GB described above with reference to FIGS. 3A and 3B. However, embodiments of the disclosure are not limited thereto.

In an embodiment, the first gate emission signal generator 310 and the second gate emission signal generator 320 may be electrically connected to the same second clock line CKL2. For example, the first gate emission signal generator 310 and the second gate emission signal generator 320 may share the same clock line. Accordingly, the integration of the gate emission driver 300 may be improved (e.g., decreased or reduced). Since the first gate emission signal generator 310 and the second gate emission signal generator 320 share the same clock line, the power consumption of the gate emission driver 300 may be reduced because there is no need to output an additional clock signal. For example, the first gate emission signal generator 310 and the second gate emission signal generator 320 may share the same clock line without the additional clock signal, and the power consumption of the gate emission driver 300 may be decreased.

The first gate emission signal generator 310 and the second gate emission signal generator 320 may be electrically connected to the same first low voltage line VLL1. For example, the first gate emission signal generator 310 and the second gate emission signal generator 320 may share the same first low voltage line VLL1. Accordingly, the integration of the gate emission driver 300 may be further improved (e.g., decreased or reduced). Since the first gate emission signal generator 310 and the second gate emission signal generator 320 share the same first low voltage line VLL1, the power consumption of the gate emission driver 300 may be further reduced. For example, the first gate emission signal generator 310 and the second gate emission signal generator 320 may share the same first low voltage line VLL1 without an additional low voltage line, and the power consumption of the gate emission driver 300 may be decreased.

Referring again to FIGS. 1, 3A, and 3B, the first driver DRV1 and the second driver DRV2 may correspond to the gate emission driver 300 (e.g., refer to FIG. 2). For example, each of the first driver DRV1 and the second driver DRV2 may include the first gate emission signal generator 310 (e.g., refer to FIG. 6) and the second gate emission signal generator 320 (e.g., refer to FIG. 6).

In an embodiment, a first driving signal generated by the first gate emission signal generator 310 of the first driver DRV1 may be the emission signal EM, and a second driving signal generated by the second gate emission signal generator 320 of the first driver DRV1 may be a gate signal of any one of the compensation gate signal GC, the initialization gate signal GI, and the bias gate signal GB. A first driving signal generated by the first gate emission signal generator 310 of the second driver DRV2 may be different from the second driving signal of the first driver DRV1, and may be a gate signal of any one of the compensation gate signal GC, the initialization gate signal GI, and the bias gate signal GB. The second driving signal generated by the second gate emission signal generator 320 of the second driver DRV2 may be a gate signal different from the second driving signal of the first driver DRV1 and the first driving signal of the second driver DRV2.

For example, the first driving signal of the first driver DRV1 may be the emission signal EM, the second driving signal of the first driver DRV1 may be the bias gate signal GB, the first driving signal of the second driver DRV2 may be the compensation gate signal GC, and the second driving signal of the second driver DRV2 may be the initialization gate signal GI. However, embodiments of the disclosure are not limited thereto.

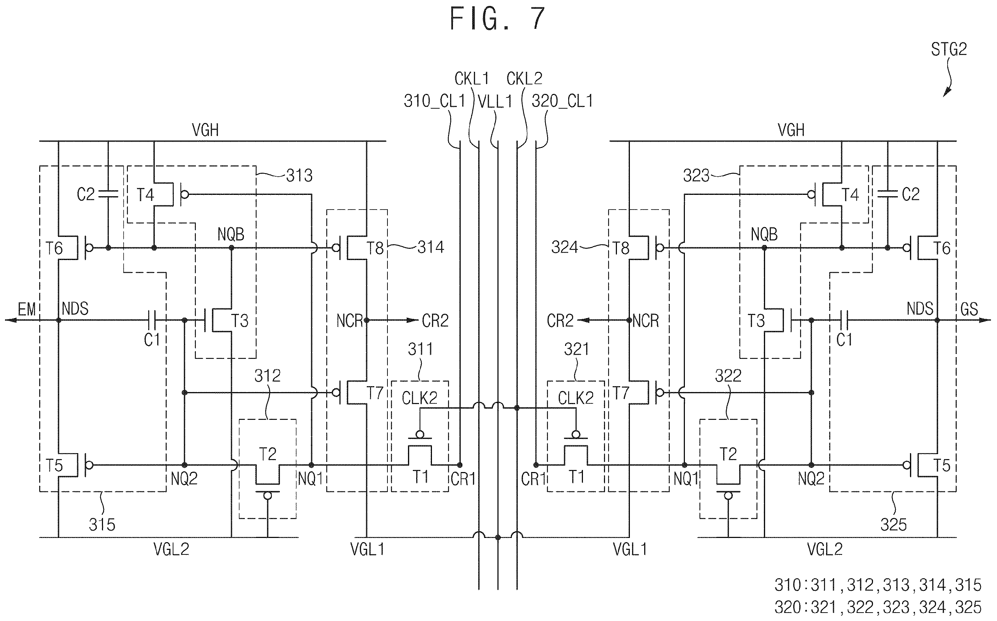

FIG. 7 is a schematic diagram of an equivalent circuit illustrating an example of a stage included in the gate emission driver of FIG. 5.

Referring to FIGS. 5, 6, and 7, each stage (e.g., the second stage STG2) may include the first gate emission signal generator 310 and the second gate emission signal generator 320. The first gate emission signal generator 310 may include an input circuit 311, a voltage limiting circuit 312, an inversion circuit 313, a carry signal output circuit 314, and a driving signal output circuit 315. The second gate emission signal generator 320 may include an input circuit 321, a voltage limiting circuit 322, an inversion circuit 323, a carry signal output circuit 324, and a driving signal output circuit 325. The first gate emission signal generator 310 and the second gate emission signal generator 320 may have circuit structures that are substantially identical or symmetrical to each other.

Each of the input circuits 311 and 321 may receive an input signal (e.g., the first carry signal CR1). For example, the input circuit 311 of the first gate emission signal generator 310 may receive the first carry signal CR1 from a carry line 310_CL1 of the first gate emission signal generator 310. The input circuit 321 of the second gate emission signal generator 320 may receive the first carry signal CR1 from a carry line 320_CL1 of the second gate emission signal generator 320.

Each of the input circuits 311 and 321 may output the first carry signal CR1 to each of control nodes NQ1 and NQ2 in response to a clock signal (e.g., the second clock signal CLK2). The control nodes NQ1 and NQ2 may include a first control node NQ1 and a second control node NQ2.

Each of the input circuits 311 and 321 may include a first transistor T1. The first transistor T1 may include a gate electrode receiving the second clock signal CLK2, a first electrode receiving the first carry signal CR1, and a second electrode electrically connected to the first control node NQ1. In an embodiment, the first transistor T1 may be a p-type transistor.

Each of the voltage limiting circuits 312 and 322 may limit voltages of the control nodes NQ1 and NQ2 based on a second low gate voltage VGL2. Each of the voltage limiting circuits 312 and 322 may include a second transistor T2. The second transistor T2 may include a gate electrode receiving the second low gate voltage VGL2, a first electrode electrically connected to the first control node NQ1, and a second electrode electrically connected to the second control node NQ2. In an embodiment, the second transistor T2 may be a p-type transistor.

Each of the inversion circuits 313 and 323 may invert voltages of the control nodes NQ1 and NQ2 and may output the voltage (e.g., the inverted voltage) to an inversion control node NQB. The inversion circuit 313 and 323 may include a third transistor T3 and a fourth transistor T4. The third transistor T3 may include a gate electrode electrically connected to the second control node NQ2, a first electrode receiving the second low gate voltage VGL2, and a second electrode electrically connected to the inversion control node NQB. The fourth transistor T4 may include a gate electrode electrically connected to the first control node NQ1, a first electrode receiving a high gate voltage VGH, and a second electrode electrically connected to the inversion control node NQB. In an embodiment, the third transistor T3 may be an n-type transistor, and the fourth transistor T4 may be a p-type transistor.

Each of the carry signal output circuits 314 and 324 may output a carry signal (e.g., the second carry signal CR2). Each of the carry signal output circuits 314 and 324 may output the first low gate voltage VGL1 to a carry output node NCR in response to a voltage of the second control node NQ2, and may output the high gate voltage VGH to the carry output node NCR in response to a voltage of the inversion control node NQB. In an embodiment, the second low gate voltage VGL2 may be lower than the first low gate voltage VGL1.

Each of the carry signal output circuits 314 and 324 may include a seventh transistor T7 and an eighth transistor T8. The seventh transistor T7 may include a gate electrode electrically connected to the second control node NQ2, a first electrode receiving the first low gate voltage VGL1, and a second electrode electrically connected to the carry output node NCR. The eighth transistor T8 may include a gate electrode electrically connected to the inversion control node NQB, a first electrode receiving the high gate voltage VGH, and a second electrode electrically connected to the carry output node NCR. In an embodiment, the seventh transistor T7 and the eighth transistor T8 may be p-type transistors.

Each of the driving signal output circuits 315 and 325 may output a driving signal. In an embodiment, the driving signal output circuit 315 of the first gate emission signal generator 310 may output the emission signal EM, and the driving signal output circuit 325 of the second gate emission signal generator 320 may output the gate signal GS. The gate signal GS may correspond to the bias gate signal GB described above with reference to FIGS. 3A and 3B, but embodiments of the disclosure are not limited thereto.

Each of the driving signal output circuits 315 and 325 may output the second low gate voltage VGL2, which is lower than the first low gate voltage VGL1, to a driving output node NDS in response to a voltage from the second control node NQ2, and may output the high gate voltage VGH to the driving output node NDS in response to a voltage from the inversion control node NQB.

Each of the driving signal output circuits 315 and 325 may include a fifth transistor T5 and a sixth transistor T6. The fifth transistor T5 may include a gate electrode electrically connected to the second control node NQ2, a first electrode receiving the second low gate voltage VGL2, and a second electrode electrically connected to the driving output node NDS. The sixth transistor T6 may include a gate electrode electrically connected to the inversion control node NQB, a first electrode receiving the high gate voltage VGH, and a second electrode electrically connected to the driving output node NDS. In an embodiment, the seventh transistor T7 and the eighth transistor T8 may be p-type transistors.

In an embodiment, each of the driving signal output circuits 315 and 325 may further include a first capacitor C1 and a second capacitor C2. The first capacitor C1 may include a first electrode electrically connected to the second control node NQ2 and a second electrode electrically connected to the driving output node NDS. The second capacitor C2 may include a first electrode receiving the high gate voltage VGH and a second electrode electrically connected to the inversion control node NQB.

In an embodiment, the seventh transistor T7 of each of the carry signal output circuits 314 and 324 and the fifth transistor T5 of each of the driving signal output circuits 315 and 325 may be p-type transistors. Accordingly, threshold voltages of the fifth transistor T5 and the seventh transistor T7 may be prevented from being shifted in a negative direction. The dead space of the gate emission driver 300 may be reduced because sizes of the fifth transistor T5 and the seventh transistor T7 do not need to be formed large for mobility compensation of the fifth transistor T5 and the seventh transistor T7. Herein, the term "dead space" may be understood as a space which is devoted to accommodating one or more components that, ether singularly or plurally, perform an intended function. For example, the fifth transistor T5 and the seventh transistor T7 may be the p-type transistors, and the fifth transistor T5 and the seventh transistor T7 may be formed without the mobility compensation. Thus, the sizes of the fifth transistor T5 and the seventh transistor T7 may be decreased, and the dead space of the gate emission driver 300 may be reduced.

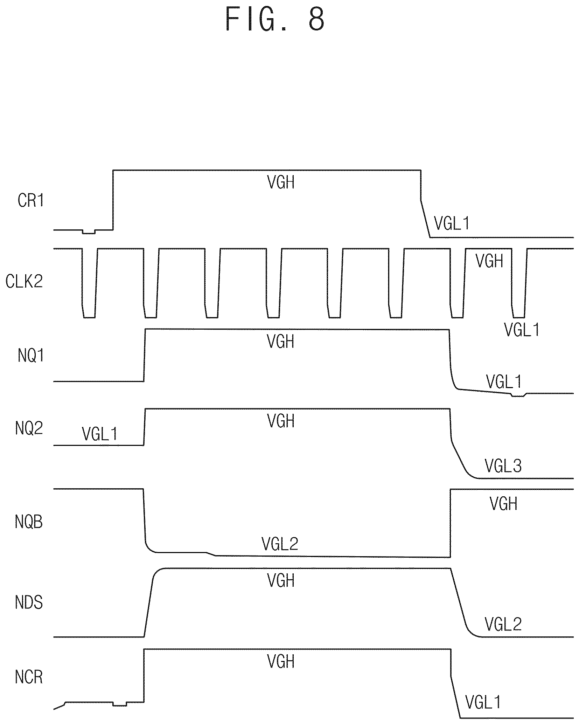

FIG. 8 is a schematic timing diagram illustrating an example of an operation of the stage of FIG. 7.

Referring to FIGS. 5, 6, 7, and 8, each of the input circuits 311 and 321 may output the first carry signal CR1 to the control nodes NQ1 and NQ2 in response to the second clock signal CLK2. For example, the first transistor T1 may receive the first carry signal CR1 in response to the second clock signal CLK2 having the first low gate voltage VGL1, and may output the first carry signal CR1 to the first control node NQ1. Accordingly, the first carry signal CR1 may be delayed by a horizontal period by each of the input circuits 311 and 321 and may be output to the first control node NQ1.

For example, in case that the second clock signal CLK2 has the first low gate voltage VGL1, the first transistor T1 may receive the first carry signal CR1 having the high gate voltage VGH in response to the second clock signal CLK2. The first transistor T1 may output the first carry signal CR1 having the high gate voltage VGH to the first control node NQ1. Accordingly, the first control node NQ1 may have the high gate voltage VGH.

Each of the voltage limiting circuits 312 and 322 may output a voltage of the first control node NQ1 to the second control node NQ2. For example, the second transistor T2 may output the voltage of the first control node NQ1 to the second control node NQ2. The second control node NQ2 may have the high gate voltage VGH.

Each of the inversion circuits 313 and 323 may invert the voltages of the control nodes NQ1 and NQ2 and output the voltage (e.g., the inverted voltage) to the inversion control node NQB. For example, in case that the second control node NQ2 has a high level, the third transistor T3 may output the second low gate voltage VGL2 to the inversion control node NQB in response to the voltage of the second control node NQ2. In case that the first control node NQ1 has a low level, the fourth transistor T4 may output the high gate voltage VGH to the inversion control node NQB in response to the voltage of the first control node NQ1. Accordingly, the inversion control node NQB may have a voltage of a phase inverted with respect to the voltages of the control nodes NQ1 and NQ2 by each of the inversion circuits 313 and 323.

For example, in case that the second control node NQ2 has the high gate voltage VGH, the third transistor T3 may output the second low gate voltage VGL2 to the inversion control node NQB in response to the voltage of the second control node NQ2. The inversion control node NQB may have the second low gate voltage VGL2.

Each of the carry signal output circuits 314 and 324 may output a carry signal (e.g., the second carry signal CR2). Each of the carry signal output circuits 314 and 324 may output the first low gate voltage VGL1 to the carry output node NCR in response to the voltage of the second control node NQ2, and may output the high gate voltage VGH to the carry output node NCR in response to the voltage of the inversion control node NQB.

For example, in case that the inversion control node NQB has a low level, the eighth transistor T8 may output the high gate voltage VGH to the carry output node NCR in response to the voltage of the inversion control node NQB. In case that the second control node NQ2 has a low level, the seventh transistor T7 may output the first low gate voltage VGL1 to the carry output node NCR in response to the voltage of the second control node NQ2.

For example, in case that the inversion control node NQB has the second low gate voltage VGL2, the eighth transistor T8 may output the high gate voltage VGH to the carry output node NCR in response to the voltage of the inversion control node NQB. The carry output node NCR may have the high gate voltage VGH.

Each of the driving signal output circuits 315 and 325 may output a driving signal. Each of the driving signal output circuits 315 and 325 may output the second low gate voltage VGL2 to the driving output node NDS in response to the voltage of the second control node NQ2, and may output the high gate voltage VGH to the driving output node NDS in response to the voltage of the inversion control node NQB.

For example, in case that the inversion control node NQB has a low level, the sixth transistor T6 may output the high gate voltage VGH to the driving output node NDS in response to the voltage of the inversion control node NQB. In case that the second control node NQ2 has a low level, the fifth transistor T5 may output the second low gate voltage VGL2 to the driving output node NDS in response to the voltage of the second control node NQ2.

For example, in case that the inversion control node NQB has the second low gate voltage VGL2, the sixth transistor T6 may output the high gate voltage VGH to the driving output node NDS in response to the voltage of the inversion control node NQB. The driving output node NDS may have the high gate voltage VGH.

In case that the voltage of the driving output node NDS changes, the voltage of the second control node NQ2 may be bootstrapped while a voltage stored between the two electrodes of the first capacitor C1 is maintained. For example, in case that the voltage of the driving output node NDS changes and the voltage is stored between the two electrodes of the first capacitor C1, the voltage of the second control node NQ2 may be bootstrapped. For example, in case that the voltage of the driving output node NDS decreases from the high gate voltage VGH to the second low gate voltage VGL2, the voltage of the second control node NQ2 may be bootstrapped to a third low gate voltage VGL3 lower than the second low gate voltage VGL2.

Since the bootstrapped voltage of the second control node NQ2 is lower than the second low gate voltage VGL2, the fifth transistor T5 and the seventh transistor T7 may be turned on, and the operation reliability of the fifth transistor T5 and the seventh transistor T7 may be improved (e.g., increased).

The voltage limiting circuits 312 and 322 may limit the voltages of the control nodes NQ1 and NQ2 based on the second low gate voltage VGL2. For example, each of the voltage limiting circuits 312 and 322 may limit the voltage flow from the bootstrapped voltage of the second control node NQ2 to the first control node NQ1. Accordingly, the bootstrapped voltage of the second control node NQ2 may be maintained.

In an embodiment, each of the driving signal output circuits 315 and 325 may output the second low gate voltage VGL2 or the high gate voltage VGH, and each of the carry signal output circuits 314 and 324 may output the first low gate voltage VGL1 or the high gate voltage VGH. The second low gate voltage VGL2 may be lower than the first low gate voltage VGL1. A voltage swing width between the high gate voltage VGH and the first low gate voltage VGL1 output by each of the carry signal output circuits 314 and 324 may be smaller than a voltage swing width between the high gate voltage VGH and the second low gate voltage VGL2 output by each of the driving signal output circuits 315 and 325. Accordingly, the power consumption of the gate emission driver 300 may be reduced.

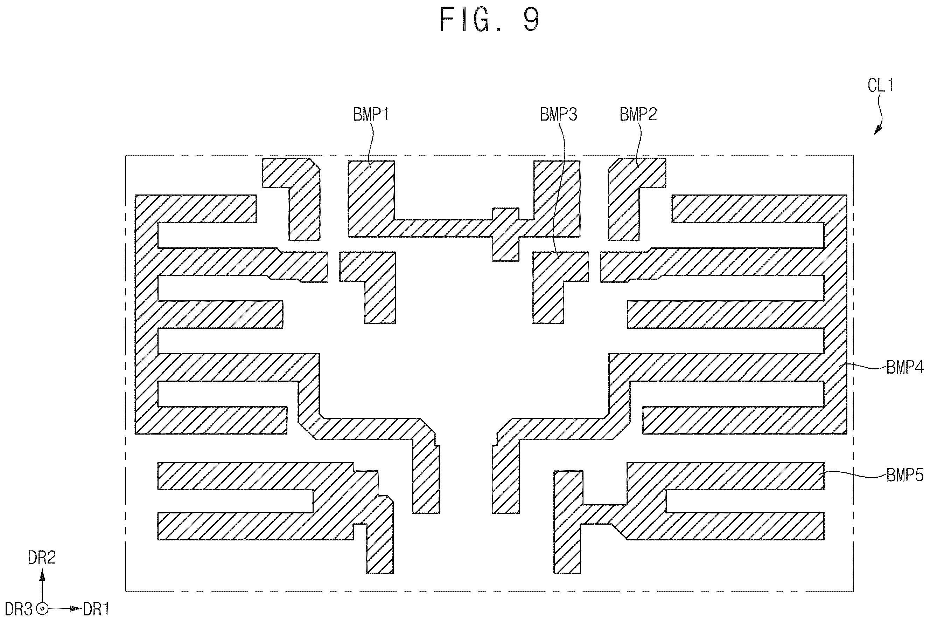

FIGS. 9 to 21 are schematic layout views illustrating an example of a stage included in the gate emission driver of FIG. 5. FIG. 9 is a schematic layout view illustrating a first conductive layer CL1.

Referring to FIGS. 4, 7, and 9, the first conductive layer CL1 may be disposed (e.g., arranged) on the substrate SUB. The first conductive layer CL1 may include at least one conductive material of a metal, an alloy, a conductive metal nitride, a conductive metal oxide, and a transparent conductive oxide. However, embodiments of the disclosure are not limited thereto. The first conductive layer CL1 may include first to fifth lower conductive patterns BMP1, BMP2, BMP3, BMP4, and BMP5. The first to fifth lower conductive patterns BMP1, BMP2, BMP3, BMP4, and BMP5 may be spaced apart from each other. The first to fifth lower conductive patterns BMP1, BMP2, BMP3, BMP4, and BMP5 may be disposed (e.g., arranged) in the same layer as the first lower electrode BME1 of FIG. 4.

The buffer layer BUF may be disposed (e.g., arranged) on the first conductive layer CL1. The buffer layer BUF may cover the first conductive layer CL1. The buffer layer BUF may include an inorganic insulating material.

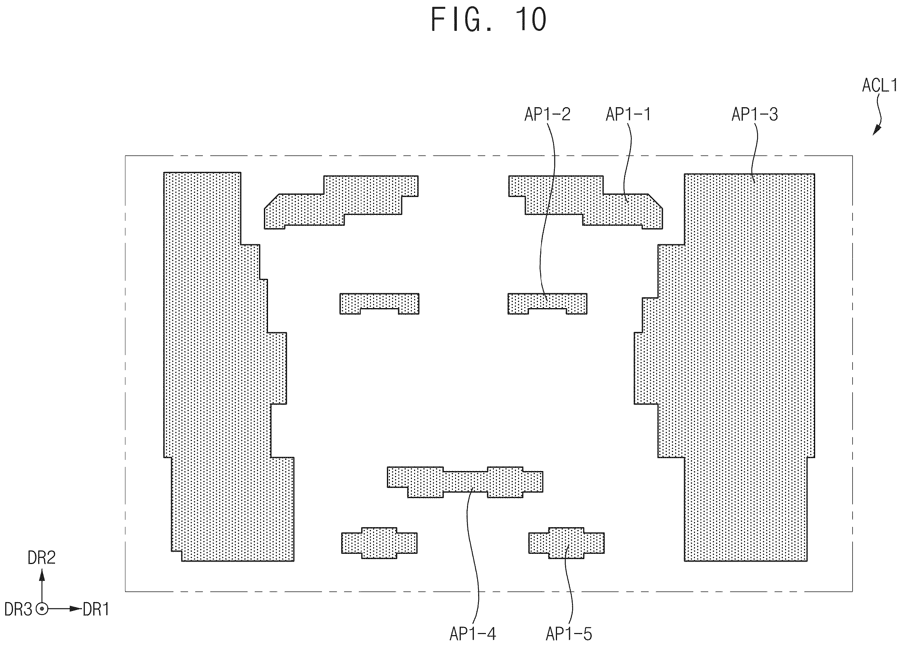

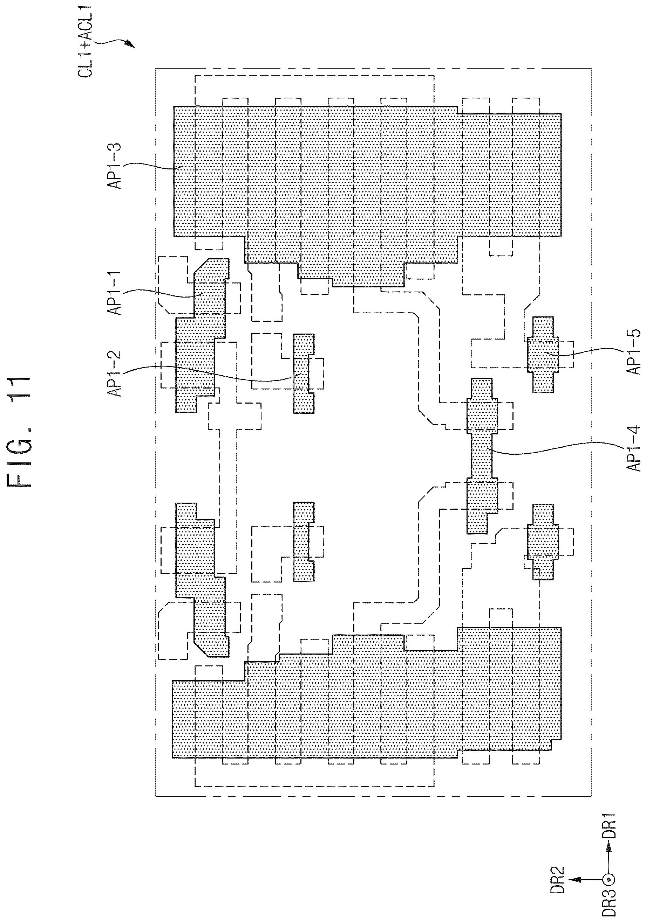

FIG. 10 is a schematic layout view illustrating a first active layer ACL1. FIG. 11 is a schematic layout view in which the first active layer ACL1 is further disposed (e.g., arranged) on the first conductive layer CL1 of FIG. 9.

Referring further to FIGS. 10 and 11, the first active layer ACL1 may be disposed (e.g., arranged) on the first conductive layer CL1. For example, the first active layer ACL1 may be disposed (e.g., arranged) on the buffer layer BUF (e.g., refer to FIG. 4).

In an embodiment, the first active layer ACL1 may include a silicon semiconductor material. The silicon semiconductor material of the first active layer ACL1 may include at least one of amorphous silicon, and polycrystalline silicon. However, embodiments of the disclosure are not limited thereto.

The first active layer ACL1 may include a first-first active pattern AP1-1, a first-second active pattern AP1-2, a first-third active pattern AP1-3, a first-fourth active pattern AP1-4, and a first-fifth active pattern AP1-5. The first-first active pattern AP1-1, the first-second active pattern AP1-2, the first-third active pattern AP1-3, the first-fourth active pattern AP1-4, and the first-fifth active pattern AP1-5 may be spaced apart from each other. The first-first active pattern AP1-1, the first-second active pattern AP1-2, the first-third active pattern AP1-3, the first-fourth active pattern AP1-4, and the first-fifth active pattern AP1-5 may be disposed (e.g., arranged) in the same layer as the first pixel active pattern PACT1 of FIG. 4.

The first lower conductive pattern BMP1 (e.g., refer to FIG. 9) may overlap the first-first active pattern AP1-1 in a plan view. A portion of the first lower conductive pattern BMP1 overlapping the first-first active pattern AP1-1 in a plan view may be a lower gate electrode of the first transistor T1.

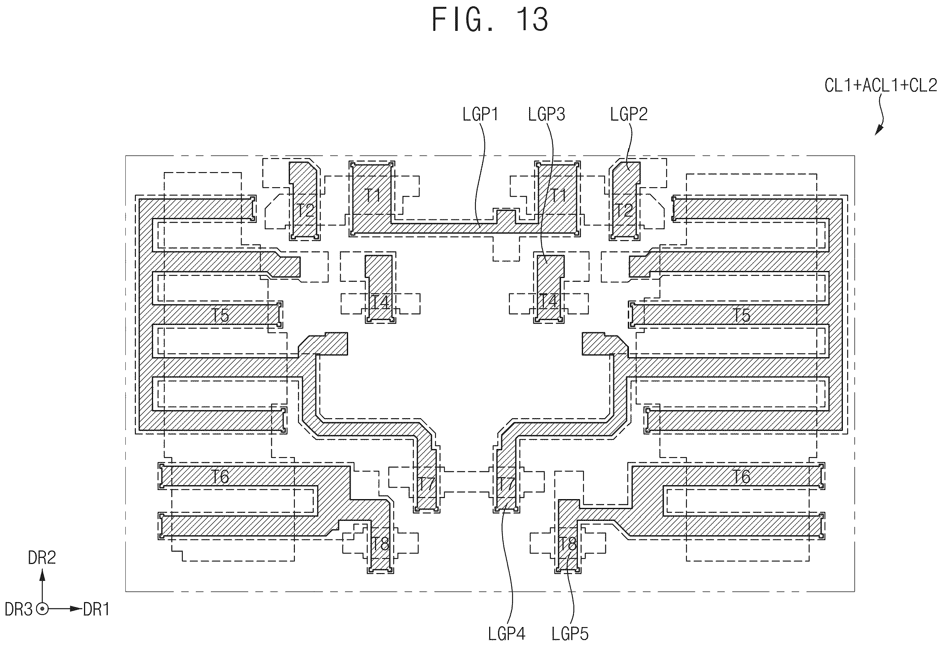

The second lower conductive pattern BMP2 (e.g., refer to FIG. 9) may overlap the first-first active pattern AP1-1 in a plan view. A portion of the second lower conductive pattern BMP2 overlapping the first-first active pattern AP1-1 in a plan view may be a lower gate electrode of the second transistor T2 (e.g., refer to FIG. 13).

The third lower conductive pattern BMP3 (e.g., refer to FIG. 9) may overlap the first-second active pattern AP1-2 in a plan view. A portion of the third lower conductive pattern BMP3 overlapping the first-second active pattern AP1-2 in a plan view may be a lower gate electrode of the fourth transistor T4 (e.g., refer to FIG. 13).

The fourth lower conductive pattern BMP4 (e.g., refer to FIG. 9) may overlap the first-third active pattern AP1-3 and the first-fourth active pattern AP1-4 in a plan view. A first portion of the fourth lower conductive pattern BMP4 overlapping the first-third active pattern AP1-3 in a plan view may be a lower gate electrode of the fifth transistor T5. A second portion of the fourth lower conductive pattern BMP4 overlapping the first-fourth active pattern AP1-4 in a plan view may be a lower gate electrode of the seventh transistor T7 (e.g., refer to FIG. 13).

The fifth lower conductive pattern BMP5 (e.g., refer to FIG. 9) may overlap the first-third active pattern AP1-3 and the first-fifth active pattern AP1-5 in a plan view. A first portion of the fifth lower conductive pattern BMP5 overlapping the first-third active pattern AP1-3 in a plan view may be a lower gate electrode of the sixth transistor T6. A second portion of the fifth lower conductive pattern BMP5 overlapping the first-fifth active pattern AP1-5 in a plan view may be a lower gate electrode of the eighth transistor T8 (e.g., refer to FIG. 13).

The first gate insulating layer GI1 may be disposed (e.g., arranged) on the first active layer ACL1. The first gate insulating layer GI1 may cover the first-first active pattern AP1-1, the first-second active pattern AP1-2, the first-third active pattern AP1-3, the first-fourth active pattern AP1-4, and the first-fifth active pattern AP1-5. The first gate insulating layer GI1 may include an inorganic insulating material.

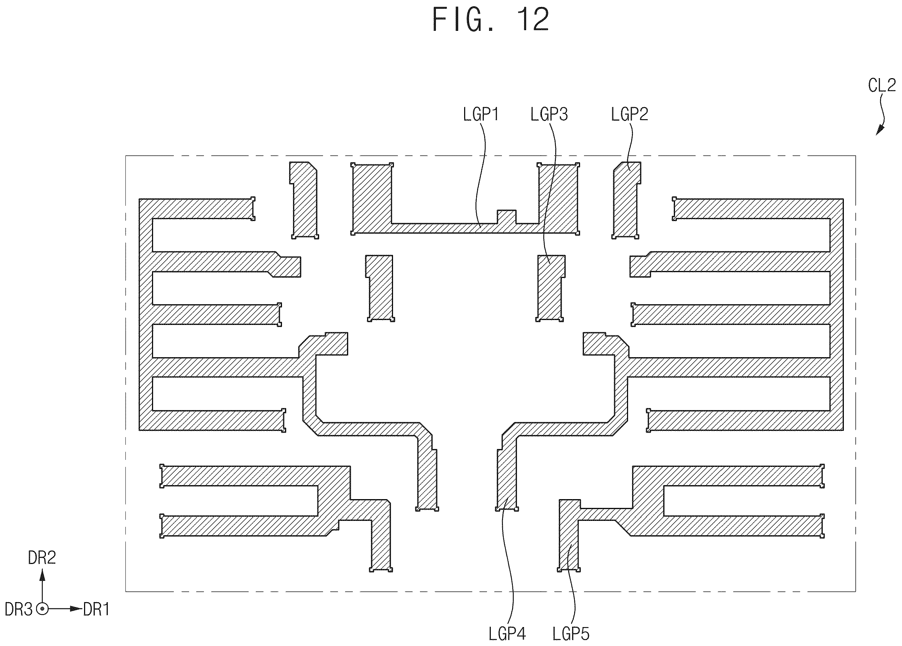

FIG. 12 is a schematic layout view illustrating a second conductive layer CL2. FIG. 13 is a schematic layout view in which the second conductive layer CL2 is further disposed (e.g., arranged) on the first active layer ACL1 of FIG. 11.

Referring further to FIGS. 12 and 13, the second conductive layer CL2 may be disposed (e.g., arranged) on the first active layer ACL1. For example, the second conductive layer CL2 may be disposed (e.g., arranged) on the first gate insulating layer GI1 (e.g., refer to FIG. 4).

The second conductive layer CL2 may include at least one conductive material of a metal, an alloy, a conductive metal nitride, a conductive metal oxide, and a transparent conductive oxide. However, embodiments of the disclosure are not limited thereto. The second conductive layer CL2 may include first to fifth lower gate patterns LGP1, LGP2, LGP3, LGP4, and LGP5. The first to fifth lower gate patterns LGP1, LGP2, LGP3, LGP4, and LGP5 may be spaced apart from each other. The first to fifth lower gate patterns LGP1, LGP2, LGP3, LGP4, and LGP5 may be disposed (e.g., arranged) in the same layer as the first pixel gate electrode GE1 of FIG. 4.

The first lower gate pattern LGP1 may overlap the first-first active pattern AP1-1 in a plan view. The first lower gate pattern LGP1 may overlap the first lower conductive pattern BMP1 in a plan view. A portion of the first lower gate pattern LGP1 overlapping the first-first active pattern AP1-1 (e.g., refer to FIG. 10) in a plan view may be an upper gate electrode of the first transistor T1.

The second lower gate pattern LGP2 may overlap the first-first active pattern AP1-1 in a plan view. The second lower gate pattern LGP2 may overlap the second lower conductive pattern BMP2 in a plan view. A portion of the second lower gate pattern LGP2 overlapping the first-first active pattern AP1-1 in a plan view may be an upper gate electrode of the second transistor T2.

The third lower gate pattern LGP3 may overlap the first-second active pattern AP1-2 (e.g., refer to FIG. 10) in a plan view. The third lower gate pattern LGP3 may overlap the third lower conductive pattern BMP3 (e.g., refer to FIG. 9) in a plan view. A portion of the third lower gate pattern LGP3 overlapping the first-second active pattern AP1-2 in a plan view may be an upper gate electrode of the fourth transistor T4.

The fourth lower gate pattern LGP4 may overlap the first-third active pattern AP1-3 (e.g., refer to FIG. 10) and the first-fourth active pattern AP1-4 (e.g., refer to FIG. 10) in a plan view. The fourth lower gate pattern LGP4 may overlap the fourth lower conductive pattern BMP4 (e.g., refer to FIG. 9) in a plan view. A first portion of the fourth lower gate pattern LGP4 overlapping the first-third active pattern AP1-3 in a plan view may be an upper gate electrode of the fifth transistor T5. A second portion of the fourth lower gate pattern LGP4 overlapping the first-fourth active pattern AP1-4 in a plan view may be an upper gate electrode of the seventh transistor T7.

The fifth lower gate pattern LGP5 may overlap the first-third active pattern AP1-3 and the first-fifth active pattern AP1-5 (e.g., refer to FIG. 10) in a plan view. The fifth lower gate pattern LGP5 may overlap the fifth lower conductive pattern BMP5 (e.g., refer to FIG. 9) in a plan view. A first portion of the fifth lower gate pattern LGP5 overlapping the first-third active pattern AP1-3 in a plan view may be an upper gate electrode of the sixth transistor T6. A second portion of the fifth lower gate pattern LGP5 overlapping the first-fifth active pattern AP1-5 in a plan view may be an upper gate electrode of the eighth transistor T8.

The second gate insulating layer GI2 may be disposed (e.g., arranged) on the second conductive layer CL2. The second gate insulating layer GI2 may cover the first to fifth lower gate patterns LGP1, LGP2, LGP3, LGP4, and LGP5. The second gate insulating layer GI2 may include an inorganic insulating material.

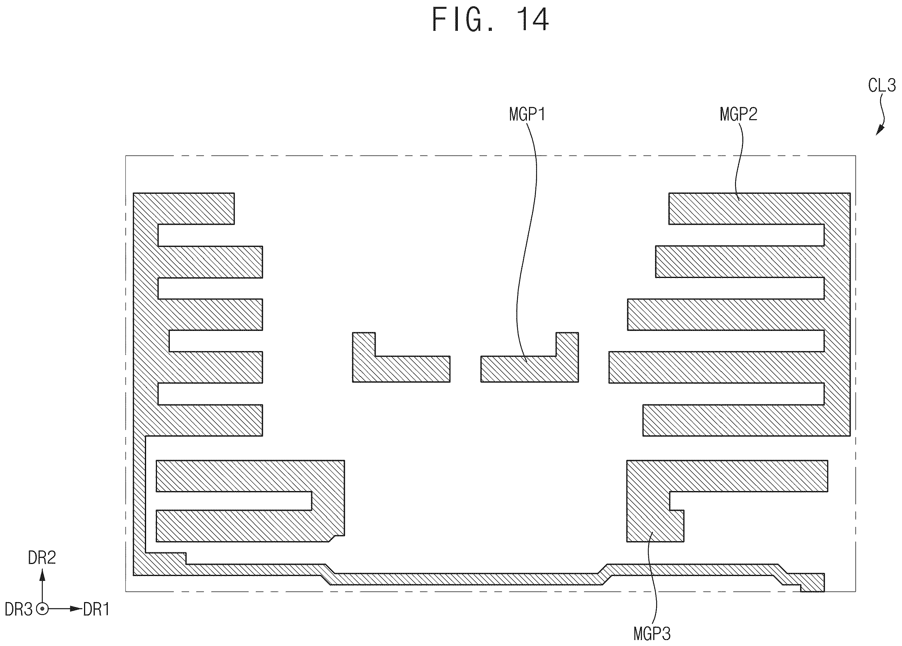

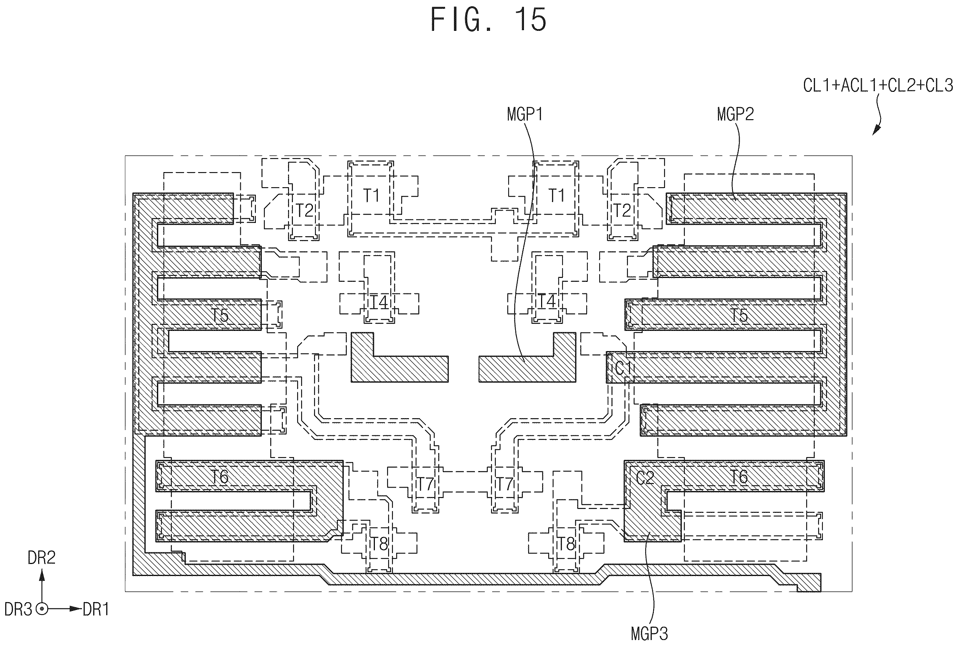

FIG. 14 is a schematic layout view illustrating a third conductive layer CL3. FIG. 15 is a schematic layout view in which the third conductive layer CL3 is further disposed (e.g., arranged) on the second conductive layer CL2 of FIG. 13.

Referring further to FIGS. 4, 14 and 15, the third conductive layer CL3 may be disposed (e.g., arranged) on the second conductive layer CL2. For example, the third conductive layer CL3 may be disposed (e.g., arranged) on the second gate insulating layer GI2 (e.g., refer to FIG. 4).

The third conductive layer CL3 may include at least one conductive material of a metal, an alloy, a conductive metal nitride, a conductive metal oxide, and a transparent conductive oxide. However, embodiments of the disclosure are not limited thereto. The third conductive layer CL3 may include first to third middle gate patterns MGP1, MGP2, and MGP3. The first to third middle gate patterns MGP1, MGP2, and MGP3 may be spaced apart from each other. The first to third middle gate patterns MGP1, MGP2, and MGP3 may be disposed (e.g., arranged) in the same layer as the capacitor electrode CAPE of FIG. 4.

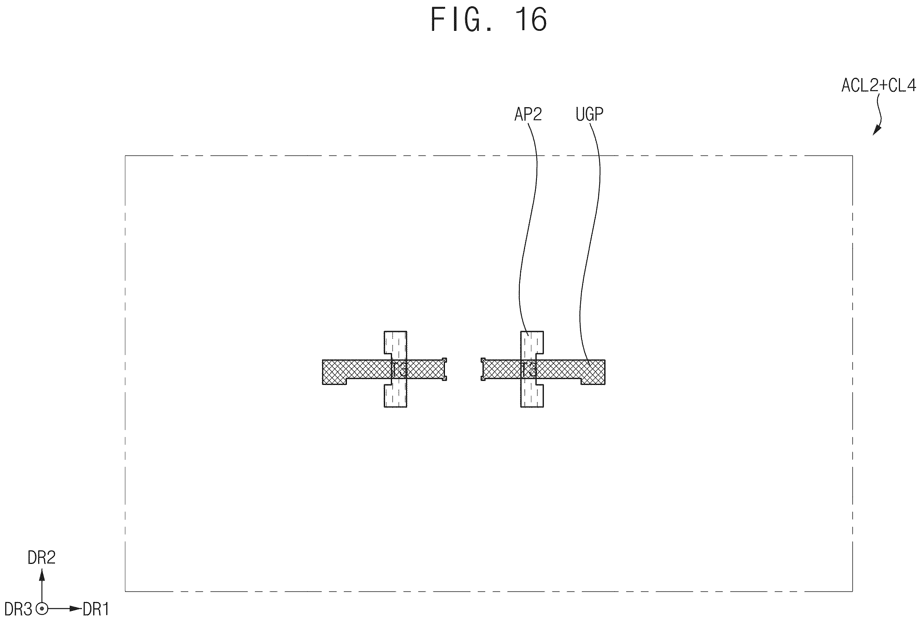

The first middle gate pattern MGP1 may overlap a second active pattern AP2 (e.g., refer to FIG. 16) described below in a plan view.

The second middle gate pattern MGP2 may overlap the fourth lower gate pattern LGP4 (e.g., refer to FIG. 12) in a plan view. The second middle gate pattern MGP2 may be spaced apart from the fourth lower gate pattern LGP4 by the second gate insulating layer GI2. The second middle gate pattern MGP2 and the fourth lower gate pattern LGP4 may form the first capacitor C1.

The third middle gate pattern MGP3 may overlap the fifth lower gate pattern LGP5 (e.g., refer to FIG. 12) in a plan view. The third middle gate pattern MGP3 may be spaced apart from the fifth lower gate pattern LGP5 by the second gate insulating layer GI2. The third middle gate pattern MGP3 and the fifth lower gate pattern LGP5 may form the second capacitor C2.

The first inter-layer insulating layer ILD1 (e.g., refer to FIG. 4) may be disposed (e.g., arranged) on the third conductive layer CL3. The first inter-layer insulating layer ILD1 may cover the first to third middle gate patterns MGP1, MGP2, and MGP3. The first inter-layer insulating layer ILD1 may include an inorganic insulating material.

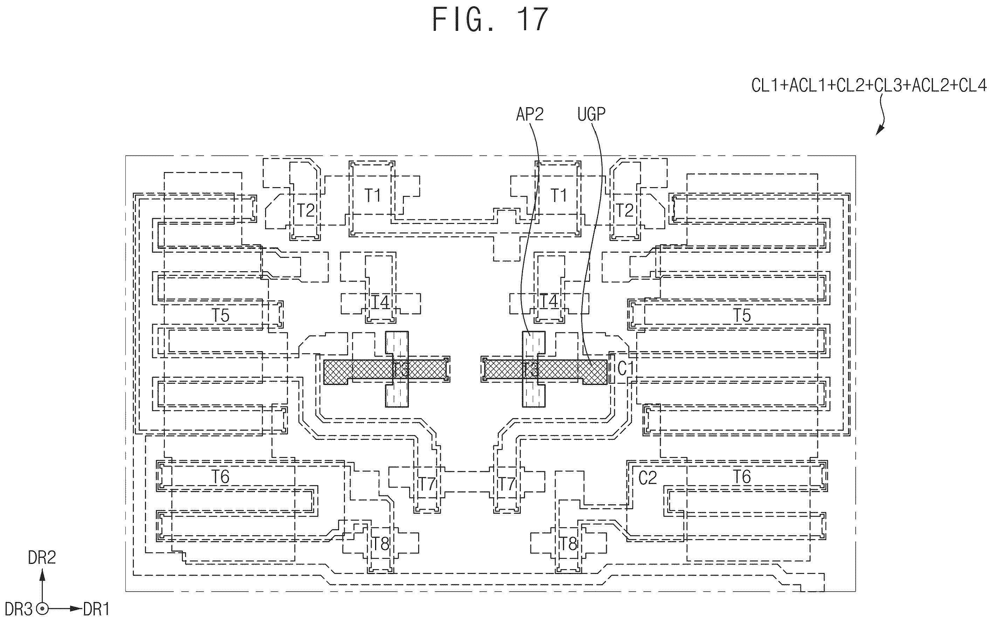

FIG. 16 is a schematic layout view illustrating a second active layer ACL2 and a fourth conductive layer CL4. FIG. 17 is a schematic layout view in which the second active layer ACL2 and the fourth conductive layer CL4 are further disposed (e.g., arranged) on the third conductive layer CL3 of FIG. 15.

Referring further to FIGS. 16 and 17, the second active layer ACL2 may be disposed (e.g., arranged) on the third conductive layer CL3. For example, the second active layer ACL2 may be disposed (e.g., arranged) on the first inter-layer insulating layer ILD1 (e.g., refer to FIG. 4).

In an embodiment, the second active layer ACL2 may include an oxide semiconductor material. For example, the oxide semiconductor material of the second active layer ACL2 may include at least one oxide of indium (In), gallium (Ga), tin (Sn), zirconium (Zr), vanadium (V), hafnium (Hf), cadmium (Cd), germanium (Ge), chromium (Cr), titanium (Ti), and zinc (Zn). The second active layer ACL2 may include a second active pattern AP2. The second active pattern AP2 may be disposed (e.g., arranged) in the same layer as the second pixel active pattern PACT2 of FIG. 4.

The first middle gate pattern MGP1 (e.g., refer to FIG. 14) may overlap the second active pattern AP2 in a plan view. A portion of the first middle gate pattern MGP1 overlapping the second active pattern AP2 in a plan view may be a lower gate electrode of the third transistor T3.

The third gate insulating layer GI3 (e.g., refer to FIG. 4) may be disposed (e.g., arranged) on the second active layer ACL2. The third gate insulating layer GI3 may cover the second active pattern AP2. The third gate insulating layer GI3 may include an inorganic insulating material.

The fourth conductive layer CL4 may be disposed (e.g., arranged) on the second active layer ACL2. For example, the fourth conductive layer CL4 may be disposed (e.g., arranged) on the third gate insulating layer GI3.

The fourth conductive layer CL4 may include at least one conductive material of a metal, an alloy, a conductive metal nitride, a conductive metal oxide, and a transparent conductive oxide. However, embodiments of the disclosure are not limited thereto. The fourth conductive layer CL4 may include an upper gate pattern UGP. The upper gate pattern UGP may be disposed (e.g., arranged) in the same layer as the second pixel gate electrode GE2 of FIG. 4.

The upper gate pattern UGP may overlap the second active pattern AP2 in a plan view. The upper gate pattern UGP may overlap the first middle gate pattern MGP1 in a plan view. A portion of the upper gate pattern UGP overlapping the second active pattern AP2 in a plan view may be an upper gate electrode of the third transistor T3.

The second inter-layer insulating layer ILD2 (e.g., refer to FIG. 4) may be disposed (e.g., arranged) on the fourth conductive layer CL4. The second inter-layer insulating layer ILD2 may cover the upper gate pattern UGP. The second inter-layer insulating layer ILD2 may include an inorganic insulating material.

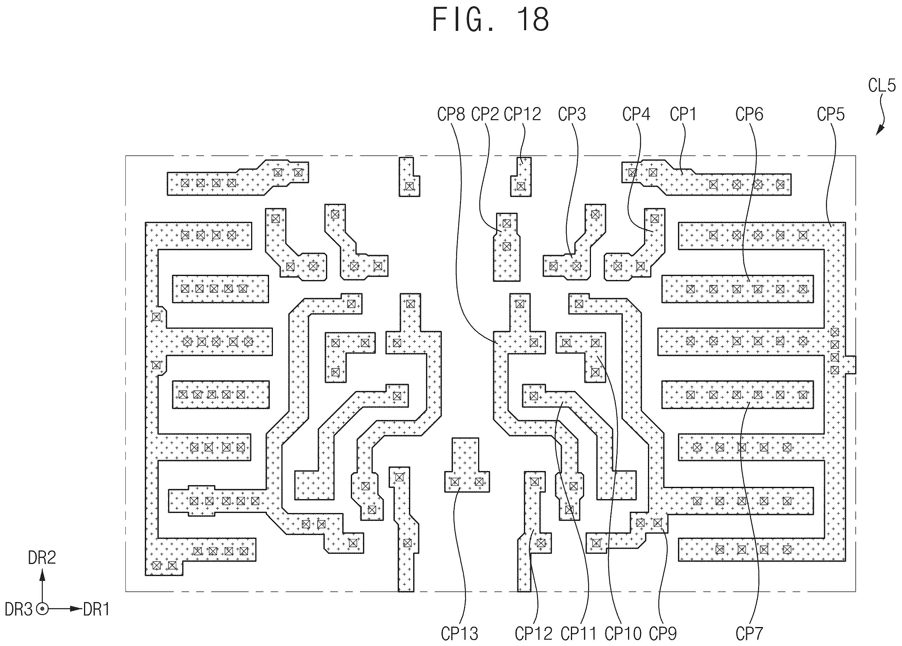

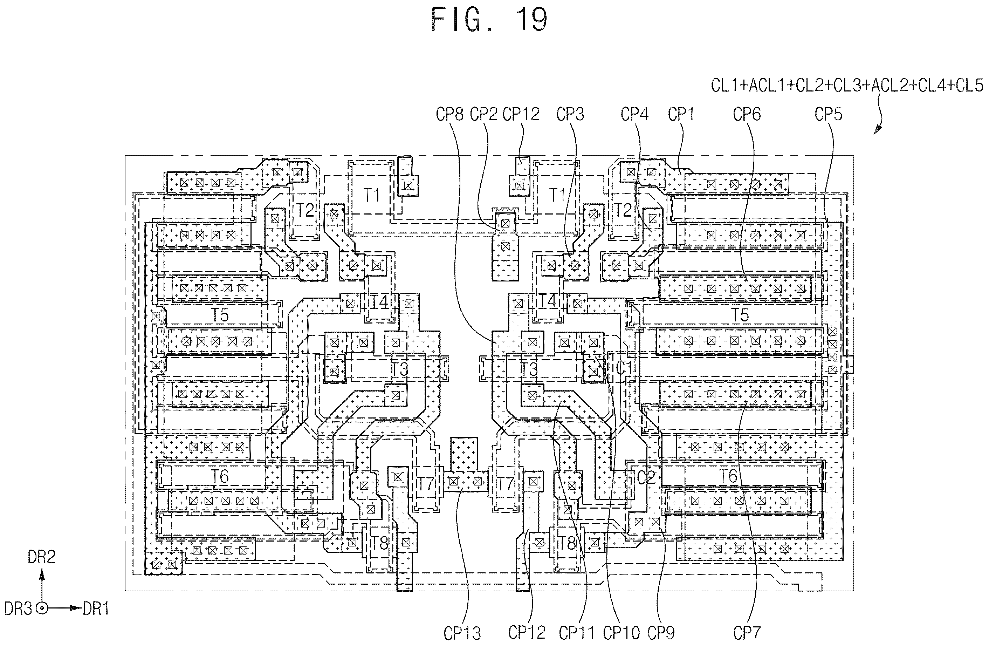

FIG. 18 is a schematic layout view illustrating a fifth conductive layer CL5. FIG. 19 is a schematic layout view in which the fifth conductive layer CL5 is further disposed (e.g., arranged) on the fourth conductive layer CL4 of FIG. 17.

Referring further to FIGS. 18 and 19, the fifth conductive layer CL5 may be disposed (e.g., arranged) on the fourth conductive layer CL4. For example, the fifth conductive layer CL5 may be disposed (e.g., arranged) on the second inter-layer insulating layer ILD2 (e.g., refer to FIG. 4).

The fifth conductive layer CL5 may include at least one conductive material of a metal, an alloy, a conductive metal nitride, a conductive metal oxide, and a transparent conductive oxide. However, embodiments of the disclosure are not limited thereto. The fifth conductive layer CL5 may include first to thirteenth connection patterns CP1, CP2, CP3, CP4, CP5, CP6, CP7, CP8, CP9, CP10, CP11, CP12, and CP13. The first to thirteenth connection patterns CP1, CP2, CP3, CP4, CP5, CP6, CP7, CP8, CP9, CP10, CP11, CP12, and CP13 may be spaced apart from each other. The first to thirteenth connection patterns CP1, CP2, CP3, CP4, CP5, CP6, CP7, CP8, CP9, CP10, CP11, CP12, and CP13 may be disposed (e.g., arranged) in the same layer as the first to fourth pixel output electrodes SE1, DE1, SE2, and DE2 of FIG. 4.

The first connection pattern CP1 may receive the second low gate voltage VGL2 (e.g., refer to FIG. 8). The first connection pattern CP1 may be electrically connected to the second lower gate pattern LGP2 (e.g., refer to FIG. 12) through a contact hole. Accordingly, the first connection pattern CP1 may provide the second low gate voltage VGL2 to the upper gate electrode of the second transistor T2.

The second connection pattern CP2 may receive the second clock signal CLK2 (e.g., refer to FIG. 8). The second connection pattern CP2 may be electrically connected to the first lower gate pattern LGP1 (e.g., refer to FIG. 12) through a contact hole. Accordingly, the second connection pattern CP2 may provide the second clock signal CLK2 to the upper gate electrode of the first transistor T1.

The third connection pattern CP3 may be electrically connected to the third lower gate pattern LGP3 (e.g., refer to FIG. 12) and the first-first active pattern AP1-1 (e.g., refer to FIG. 10) through contact holes. Accordingly, the third connection pattern CP3 may electrically connect the second transistor T2 and the upper gate electrode of the fourth transistor T4.

The fourth connection pattern CP4 may be electrically connected to the fourth lower gate pattern LGP4 (e.g., refer to FIG. 12) and the first-first active pattern AP1-1 through contact holes. Accordingly, the fourth connection pattern CP4 may electrically connect the second transistor T2 and the upper gate electrode of the fifth transistor T5.

The fifth connection pattern CP5 may be electrically connected to the first-third active pattern AP1-3 (e.g., refer to FIG. 10) through a contact hole. The fifth connection pattern CP5 may electrically connect the fifth transistor T5 and the sixth transistor T6.

The sixth connection pattern CP6 and the seventh connection pattern CP7 may receive the second low gate voltage VGL2 (e.g., refer to FIG. 8). Each of the sixth connection pattern CP6 and the seventh connection pattern CP7 may be electrically connected to the first-third active pattern AP1-3 through a contact hole. Accordingly, the sixth connection pattern CP6 and the seventh connection pattern CP7 may provide the second low gate voltage VGL2 to the fifth transistor T5.

The eighth connection pattern CP8 may be electrically connected to each of the first-second active pattern AP1-2 (e.g., refer to FIG. 10), the second active pattern AP2 (e.g., refer to FIG. 16), and the fifth lower gate pattern LGP5 (e.g., refer to FIG. 12) through contact holes. Accordingly, the eighth connection pattern CP8 may electrically connect the third transistor T3, the fourth transistor T4, and the upper gate electrode of the eighth transistor T8.

The ninth connection pattern CP9 may receive the high gate voltage VGH (e.g., refer to FIG. 8). The ninth connection pattern CP9 may be electrically connected to the first-second active pattern AP1-2 and the first-third active pattern AP1-3, the third middle gate pattern MGP3 (e.g., refer to FIG. 14) and the first-fifth active pattern AP1-5 (e.g., refer to FIG. 10) through contact holes. Accordingly, the ninth connection pattern CP9 may provide the high gate voltage VGH to the fourth transistor T4, the sixth transistor T6, the second capacitor C2, and the eighth transistor T8.

The tenth connection pattern CP10 may be electrically connected to the fourth lower gate pattern LGP4 and the upper gate pattern UGP (e.g., refer to FIG. 16) through contact holes. Accordingly, the tenth connection pattern CP10 may electrically connect the upper gate electrode of the seventh transistor T7 and the upper gate electrode of the third transistor T3.

The eleventh connection pattern CP11 may receive the second low gate voltage VGL2. The eleventh connection pattern CP11 may be electrically connected to the second active pattern AP2 through a contact hole. Accordingly, the eleventh connection pattern CP11 may provide the second low gate voltage VGL2 to the third transistor T3.

The twelfth connection pattern CP12 may be electrically connected to the first-fourth active pattern AP1-4 (e.g., refer to FIG. 10), the first-fifth active pattern AP1-5, and a first-first active pattern AP1-1 of an adjacent row (e.g., a next row) through contact holes. Accordingly, the twelfth connection pattern CP12 may electrically connect the seventh transistor T7 and the eighth transistor T8. The twelfth connection pattern CP12 may provide a carry signal to a first transistor T1 of the adjacent row (e.g., the next row). For example, the twelfth connection pattern CP12 included in a stage of the N-th row may provide the carry signal to the first transistor T1 included in a stage of the (N+1)-th row.

The thirteenth connection pattern CP13 may receive the first low gate voltage VGL1 (e.g., refer to FIG. 8). The thirteenth connection pattern CP13 may be electrically connected to the first-fourth active pattern AP1-4 through a contact hole. Accordingly, the thirteenth connection pattern CP1-3 may provide the first low gate voltage VGL1 to the seventh transistor T7.

The first via-insulating layer VIA1 (e.g., refer to FIG. 4) may be disposed (e.g., arranged) on the fifth conductive layer CL5. The first via-insulating layer VIA1 may cover the first to thirteenth connection patterns CP1, CP2, CP3, CP4, CP5, CP6, CP7, CP8, CP9, CP10, CP11, CP12, and CP13. The first via-insulating layer VIA1 may include an organic insulating material.

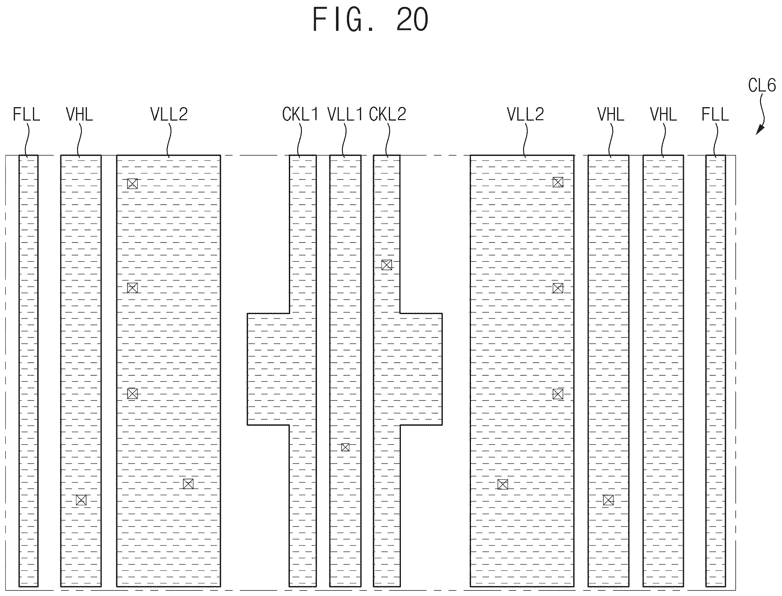

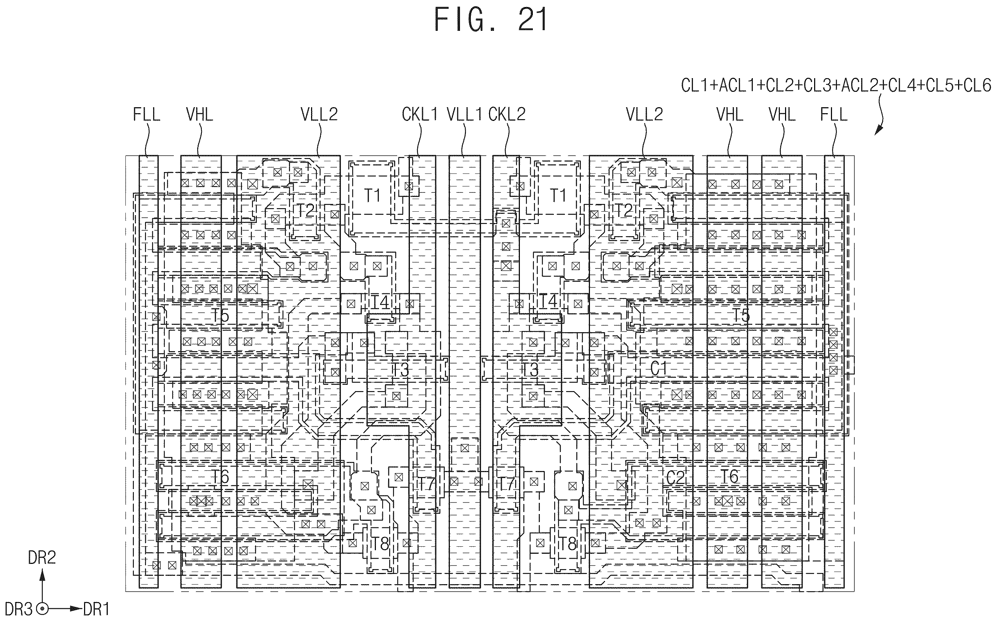

FIG. 20 is a schematic layout view illustrating a sixth conductive layer CL6. FIG. 21 is a schematic layout view in which the sixth conductive layer CL6 is further disposed (e.g., arranged) on the fifth conductive layer CL5 of FIG. 19.

Referring further to FIGS. 20 and 21, the sixth conductive layer CL6 may be disposed (e.g., arranged) on the fifth conductive layer CL5. For example, the sixth conductive layer CL6 may be disposed (e.g., arranged) on the first via-insulating layer VIA1 (e.g., refer to FIG. 4).

The sixth conductive layer CL6 may include at least one conductive material of a metal, an alloy, a conductive metal nitride, a conductive metal oxide, and a transparent conductive oxide. However, embodiments of the disclosure are not limited thereto. The sixth conductive layer CL6 may include the first low voltage line VLL1, the first clock line CKL1, the second clock line CKL2, a second low voltage line VLL2, a high voltage line VHL, and a start signal line FLL. The first low voltage line VLL1, the first clock line CKL1, the second clock line CKL2, the second low voltage line VLL2, the high voltage line VHL, and the start signal line FLL may be spaced apart from each other. For example, each of the first low voltage line VLL1, the first clock line CKL1, the second clock line CKL2, the second low voltage line VLL2, the high voltage line VHL, and the start signal line FLL may extend in the second direction DR2.

In an embodiment, the first low voltage line VLL1, the first clock line CKL1, and the second clock line CKL2 may be disposed (e.g., arranged) in the same layer as each other. For example, the first low voltage line VLL1, the first clock line CKL1, the second clock line CKL2, the second low voltage line VLL2, the high voltage line VHL, and the start signal line FLL may be disposed (e.g., arranged) in the same layer as the connection electrode LCE in FIG. 4.

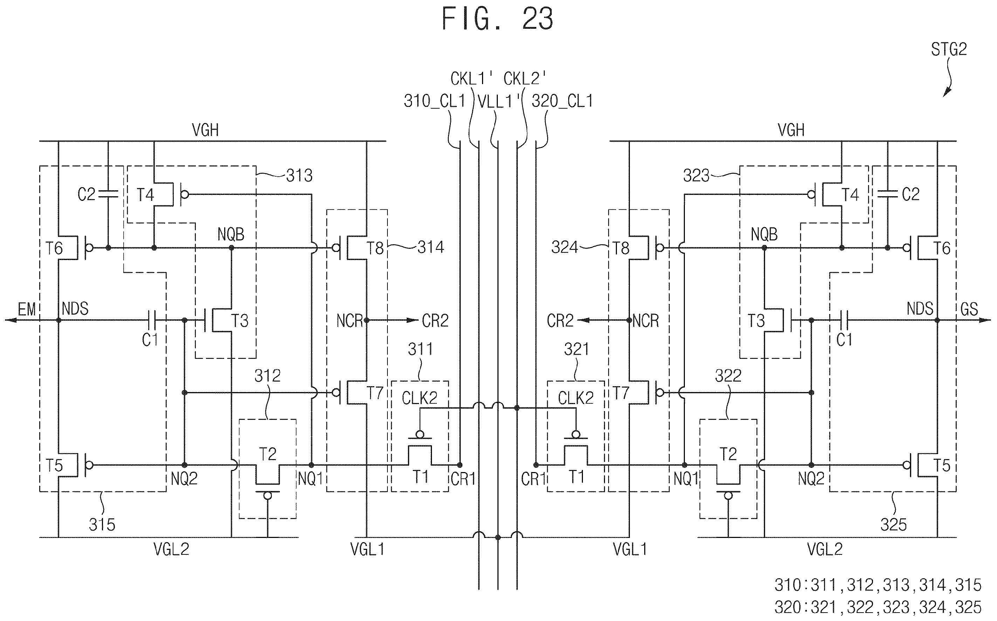

The first low voltage line VLL1 may be disposed (e.g., arranged) between the first gate emission signal generator 310 (e.g., refer to FIG. 23) and the second gate emission signal generator 320 (e.g., refer to FIG. 23). For example, a width (e.g., a length in the first direction DR1) of the first low voltage line VLL1 may be about 7.5 micrometers. In an embodiment, the first gate emission signal generator 310 and the second gate emission signal generator 320 may be line-symmetrical with respect to the first low voltage line VLL1.

In an embodiment, the first low voltage line VLL1 may be disposed (e.g., arranged) between the first clock line CKL1 and the second clock line CKL2 in a plan view. For example, the first low voltage line VLL1 may be spaced apart from each of the first clock line CKL1 and the second clock line CKL2 in a plan view. For example, a distance (e.g., a spaced distance or an interval) in a plan view between the first low voltage line VLL1 and the first clock line CKL1 may be about 3 micrometers. A distance (e.g., a spaced distance or an interval) in a plan view between the first low voltage line VLL1 and the second clock line CKL2 may be about 3 micrometers.

The first low voltage line VLL1 may be electrically connected to the thirteenth connection pattern CP13 (e.g., refer to FIG. 18) through a contact hole. The first low voltage line VLL1 may output the first low gate voltage VGL1 (e.g., refer to FIG. 8) to the thirteenth connection pattern CP13.

In an embodiment, the first gate emission signal generator 310 and the second gate emission signal generator 320 may be electrically connected to the same first low voltage line VLL1. For example, the first low voltage line VLL1 may be electrically connected to the seventh transistor T7 of the first gate emission signal generator 310 and the seventh transistor T7 of the second gate emission signal generator 320 through the thirteenth connection pattern CP13. Accordingly, the first low gate voltage VGL1 may be applied to the seventh transistor T7 of the first gate emission signal generator 310 and the seventh transistor T7 of the second gate emission signal generator 320 through the first low voltage line VLL1 and the thirteenth connection pattern CP13. For example, the first low gate voltage VGL1 may be simultaneously (or commonly) applied to the seventh transistors T7 of the first and second gate emission signal generators 310 and 320 through the first low voltage gate line VLL and the thirteenth connection pattern CP13.

The first clock line CKL1 may be disposed (e.g., arranged) between the first gate emission signal generator 310 and the second gate emission signal generator 320. The first clock line CKL1 may be spaced apart from the first low voltage line VLL1 in a plan view. FIGS. 9 to 21 are layout views illustrating the second stage STG2 (e.g., refer to FIG. 5) as an example of the stage included in the gate emission driver 300 (e.g., refer to FIG. 5), and therefore, the first clock line CKL1 may not be electrically connected to other patterns in FIGS. 20 and 21.

The second clock line CKL2 may be disposed (e.g., arranged) between the first gate emission signal generator 310 and the second gate emission signal generator 320. The second clock line CKL2 may be spaced apart from the first low voltage line VLL1 in a plan view. The second clock line CKL2 may be electrically connected to the second connection pattern CP2 (e.g., refer to FIG. 18) through a contact hole. The second clock line CKL2 may output the second clock signal CLK2 to the second connection pattern CP2.

In an embodiment, the first gate emission signal generator 310 and the second gate emission signal generator 320 may be electrically connected to the same second clock line CKL2. For example, the second clock line CKL2 may be electrically connected to the first lower gate pattern LGP1 (e.g., refer to FIG. 12) through the second connection pattern CP2. Accordingly, the second clock signal CLK2 may be applied to the upper gate electrode of the first transistor T1 of the first gate emission signal generator 310 and the upper gate electrode of the first transistor T1 of the second gate emission signal generator 320 through the second clock line CKL2 and the second connection pattern CP2. For example, the second clock signal CLK2 may be simultaneously (or commonly) applied to the upper gate electrodes of the first transistors T1 of the first and second gate emission signal generators 310 and 320 through the second clock line CKL2 and the second connection pattern CP2.

The second low voltage line VLL2 may be electrically connected to the first connection pattern CP1 (e.g., refer to FIG. 18), the sixth connection pattern CP6 (e.g., refer to FIG. 18), the seventh connection pattern CP7 (e.g., refer to FIG. 18), and the eleventh connection pattern CP11 (e.g., refer to FIG. 18) through contact holes. The second low voltage line VLL2 may output the second low gate voltage VGL2 to the first connection pattern CP1, the sixth connection pattern CP6, the seventh connection pattern CP7, and the eleventh connection pattern CP11.

The high voltage line VHL may be electrically connected to the ninth connection pattern CP9 (e.g., refer to FIG. 18) through a contact hole. The high voltage line VHL may output the high gate voltage VGH (e.g., refer to FIG. 8) to the ninth connection pattern CP9. In FIGS. 20 and 21, the high voltage line VHL that is not electrically connected to other patterns may output the high gate voltage VGH to stages (e.g., the first, third, and fourth stages STG1, STG3, and STG4, or the like) other than the second stage STG2.

As described above, FIGS. 9 to 21 are schematic layout views illustrating the second stage STG2 (e.g., refer to FIG. 5) as an example of the stage included in the gate emission driver 300 (e.g., refer to FIG. 5), and therefore, the start signal line FLL may not be electrically connected to other patterns in FIGS. 20 and 21. For example, the start signal line FLL may be electrically connected only to the first stage STG1 (e.g., refer to FIG. 5).

The second via-insulating layer VIA2 (e.g., refer to FIG. 4) may be disposed (e.g., arranged) on the sixth conductive layer CL6. The second via-insulating layer VIA2 may cover the first low voltage line VLL1, the first clock line CKL1, the second clock line CKL2, the second low voltage line VLL2, the high voltage line VHL, and the start signal line FLL. The second via-insulating layer VIA2 may include an organic insulating material.

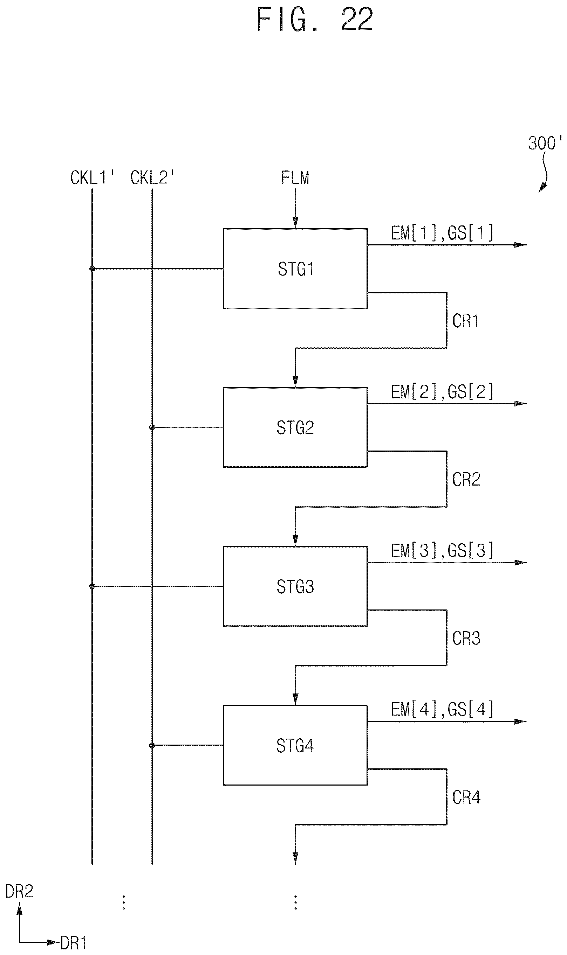

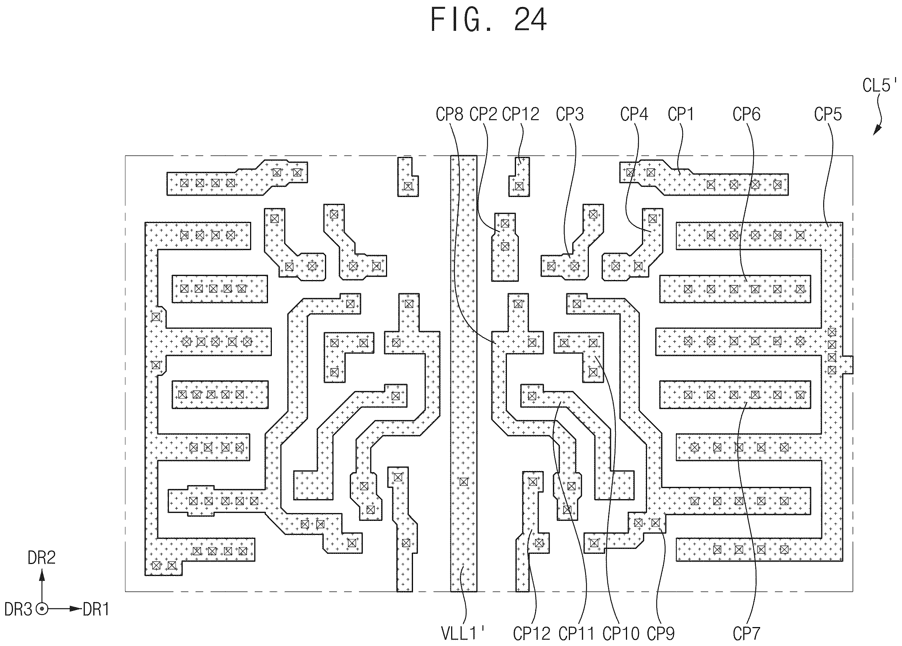

FIG. 22 is a schematic block diagram illustrating another example of a gate emission driver of FIG. 2. FIG. 23 is a schematic diagram of an equivalent circuit illustrating an example of a stage included in the gate emission driver of FIG. 22. FIGS. 24, 25, 26, and 27 are schematic layout views illustrating an example of a stage included in the gate emission driver of FIG. 22.

Referring to FIGS. 22 and 23, a gate emission driver 300' may include stages STG1, STG2, STG3, STG4, ..., a first clock line CKL1', a second clock line CKL2', and a first low voltage line VLL1'. Each of the stages STG1, STG2, STG3, STG4, ... may include a first gate emission signal generator 310 and a second gate emission signal generator 320.

The gate emission driver 300' is different from the gate emission driver 300 described above with reference to FIGS. 5 to 21 at least in that the first low voltage line VLL1' is disposed (e.g., arranged) in a different layer from the first clock line CKL1 and the second clock line CKL2. For example, a stage included in the gate emission driver 300' may include the first conductive layer CL1, the first active layer ACL1, the second conductive layer CL2, the third conductive layer CL3, the second active layer ACL2, and the fourth conductive layer CL4 described above with reference to FIGS. 5 to 17. Hereinafter, detailed description of the same or similar constituent elements of the gate emission driver 300 described above with reference to FIGS. 5 to 21 is omitted (or summarized).

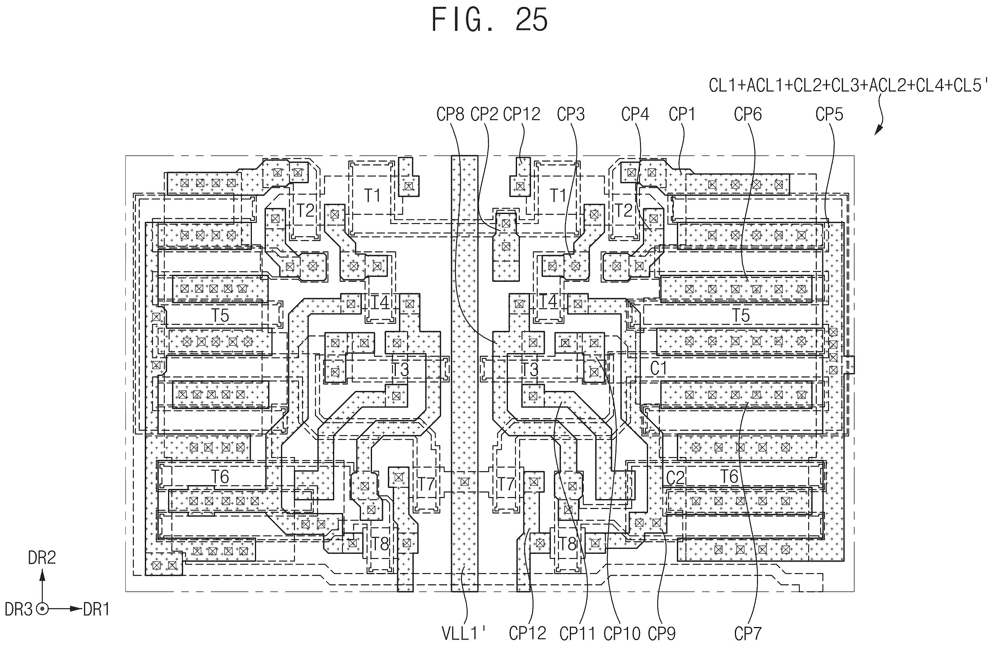

FIG. 24 is a schematic layout view illustrating a fifth conductive layer CL5'. FIG. 25 is a schematic layout view in which the fifth conductive layer CL5' is further disposed (e.g., arranged) on the fourth conductive layer CL4 of FIG. 17.

Referring further to FIGS. 4, 24, and 25, the fifth conductive layer CL5' may be disposed (e.g., arranged) on the fourth conductive layer CL4. For example, the fifth conductive layer CL5' may be disposed (e.g., arranged) on the second inter-layer insulating layer ILD2.

The fifth conductive layer CL5' may include first to twelfth connection patterns CP1, CP2, CP3, CP4, CP5, CP6, CP7, CP8, CP9, CP10, CP11, and CP12 and the first low voltage line VLL1'. The first to twelfth connection patterns CP1, CP2, CP3, CP4, CP5, CP6, CP7, CP8, CP9, CP10, CP11, and CP12 and the first low voltage line VLL1' may be spaced apart from each other. The first to twelfth connection patterns CP1, CP2, CP3, CP4, CP5, CP6, CP7, CP8, CP9, CP10, CP11, and CP12 and the first low voltage line VLL1' may be disposed (e.g., arranged) in the same layer as the first to fourth pixel output electrodes SE1, DE1, SE2, and DE2 of FIG. 4.

The first to twelfth connection patterns CP1, CP2, CP3, CP4, CP5, CP6, CP7, CP8, CP9, CP10, CP11, and CP12 of FIG. 24 may be substantially the same as the first to twelfth connection patterns CP1, CP2, CP3, CP4, CP5, CP6, CP7, CP8, CP9, CP10, CP11, and CP12 described above with reference to FIG. 18, respectively. Accordingly, detailed description of the same or similar constituent elements of the first to twelfth connection patterns CP1, CP2, CP3, CP4, CP5, CP6, CP7, CP8, CP9, CP10, CP11, and CP12 of FIG. 24 is omitted.

The first low voltage line VLL1' may be disposed (e.g., arranged) between the first gate emission signal generator 310 (e.g., refer to FIG. 23) and the second gate emission signal generator 320 (e.g., refer to FIG. 23). For example, a width (e.g., a length in the first direction DR1) of the first low voltage line VLL1' may be about 7.5 micrometers. In an embodiment, the first gate emission signal generator 310 and the second gate emission signal generator 320 may be line-symmetrical with respect to the first low voltage line VLL1'.

In an embodiment, the first gate emission signal generator 310 and the second gate emission signal generator 320 may be electrically connected to the same first low voltage line VLL1'. For example, the first low voltage line VLL1' may be electrically connected to the first-fourth active pattern AP1-4 (e.g., refer to FIG. 11) through a contact hole. For example, the first low voltage line VLL1' may be electrically connected to the seventh transistor T7 of the first gate emission signal generator 310 and the seventh transistor T7 of the second gate emission signal generator 320. Accordingly, the first low gate voltage VGL1 may be applied to the seventh transistor T7 of the first gate emission signal generator 310 and the seventh transistor T7 of the second gate emission signal generator 320 through the first low voltage line VLL1'.

The first via-insulating layer VIA1 (e.g., refer to FIG. 4) may be disposed (e.g., arranged) on the fifth conductive layer CL5'. The first via-insulating layer VIA1 may cover the first to twelfth connection patterns CP1, CP2, CP3, CP4, CP5, CP6, CP7, CP8, CP9, CP10, CP11, and CP12 and the first low voltage line VLL1'. The first via-insulating layer VIA1 may include an organic insulating material.

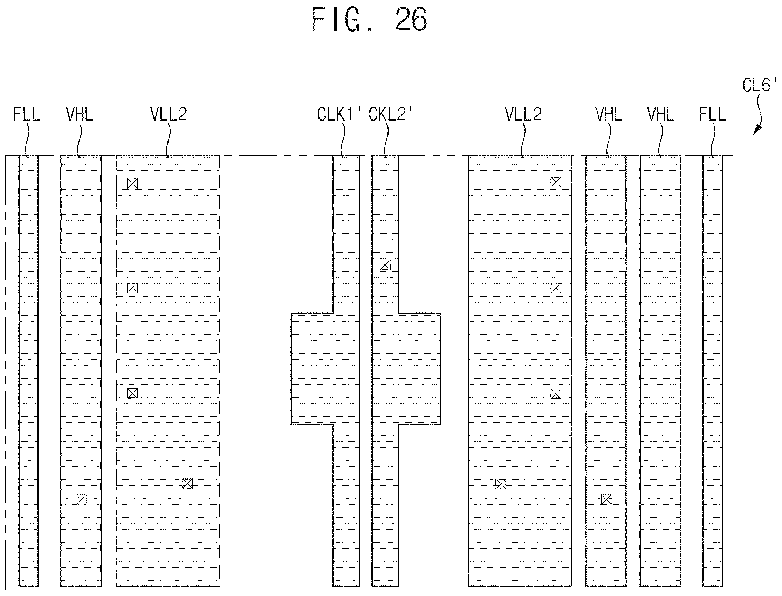

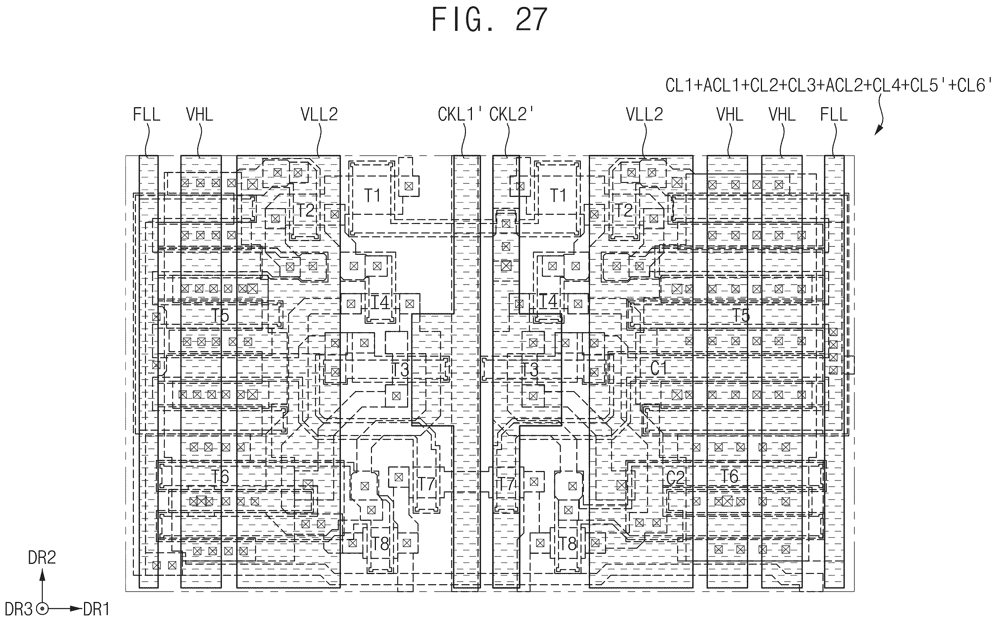

FIG. 26 is a layout view illustrating a sixth conductive layer CL6'. FIG. 27 is a layout view in which the sixth conductive layer CL6' is further disposed (e.g., arranged) on the fifth conductive layer CL5' of FIG. 25.

Referring further to FIGS. 26 and 27, the sixth conductive layer CL6' may be disposed (e.g., arranged) on the fifth conductive layer CL5' (e.g., refer to FIG. 24). For example, the sixth conductive layer CL6' may be disposed (e.g., arranged) on the first via-insulating layer VIA1 (e.g., refer to FIG. 4).

The sixth conductive layer CL6' may include the first clock line CKL1', the second clock line CKL2', a second low voltage line VLL2, a high voltage line VHL, and a start signal line FLL. The first clock line CKL1', the second clock line CKL2', the second low voltage line VLL2, the high voltage line VHL, and the start signal line FLL may be spaced apart from each other. For example, each of the first clock line CKL1', the second clock line CKL2', the second low voltage line VLL2, the high voltage line VHL, and the start signal line FLL may extend in the second direction DR2. The first clock line CKL1', the second clock line CKL2', the second low voltage line VLL2, the high voltage line VHL, and the start signal line FLL may be disposed (e.g., arranged) in the same layer as the connection electrode LCE of FIG. 4.

The second low voltage line VLL2, the high voltage line VHL, and the start signal line FLL of FIG. 26 may be substantially the same as the second low voltage line VLL2, the high voltage line VHL, and the start signal line FLL described above with reference to FIG. 20, respectively. Accordingly, detailed description of the same or similar constituent elements of the second low voltage line VLL2, the high voltage line VHL, and the start signal line FLL of FIG. 26 is omitted.

In an embodiment, the first low voltage line VLL1' (e.g., refer to FIG. 24) may be disposed (e.g., arranged) in a different layer from the first clock line CKL1' and the second clock line CKL2'. For example, the first low voltage line VLL1' may be disposed (e.g., arranged) under the first clock line CKL1' and the second clock line CKL2'.

For example, the first low voltage line VLL1' and the first to fourth pixel output electrodes SE1, DE1, SE2, and DE2 of FIG. 4 may be disposed (e.g., arranged) in the same layer as each other, and the first clock line CKL1', the second clock line CKL2', and the connection electrode LCE of FIG. 4 may be disposed (e.g., arranged) in the same layer as each other.

Each of the first clock line CKL1' and the second clock line CKL2' may be disposed (e.g., arranged) between the first gate emission signal generator 310 (e.g., refer to FIG. 23) and the second gate emission signal generator 320 (e.g., refer to FIG. 23). The first clock line CKL1' and the second clock line CKL2' may be spaced apart from each other in a plan view. For example, a distance (e.g., a spaced distance or an interval) in a plan view between the first clock line CKL1' and the second clock line CKL2' may be about 3 micrometers.

In an embodiment, the first low voltage line VLL1' may at least partially overlap the first clock line CKL1' or the second clock line CKL2' in a plan view. For example, as illustrated in FIG. 27, the first low voltage line VLL1' may at least partially overlap the first clock line CKL1' in a plan view. For example, since the first low voltage line VLL1' is disposed (e.g., arranged) in a different layer from the first clock line CKL1' and the second clock line CKL2', the integration of the gate emission driver 300' may be further improved (e.g., decreased or reduced) because the first low voltage line VLL' does not need to be spaced apart from the first clock line CKL1' and the second clock line CKL2' in a plan view.

The second via-insulating layer VIA2 (e.g., refer to FIG. 4) may be disposed (e.g., arranged) on the sixth conductive layer CL6'. The second via-insulating layer VIA2 may cover the first clock line CKL1', the second clock line CKL2', the second low voltage line VLL2, the high voltage line VHL, and the start signal line FLL. The second via-insulating layer VIA2 may include an organic insulating material.

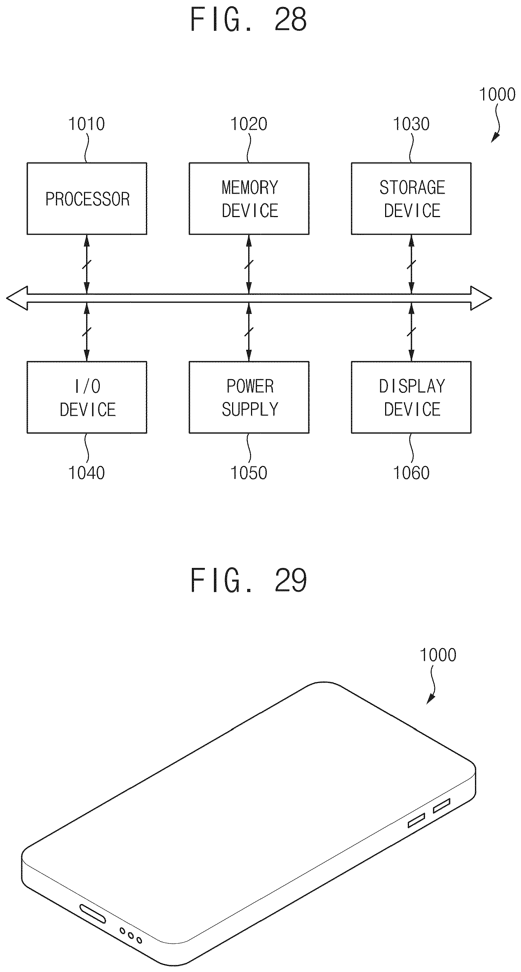

FIG. 28 is a schematic block diagram illustrating an electronic device according to an embodiment of the disclosure. FIG. 29 is a schematic view illustrating an example in which the electronic device of FIG. 28 is implemented as a smartphone.

Referring to FIGS. 28 and 29, an electronic device 1000 may include a processor 1010, a memory device 1020, a storage device 1030, an input/output (I/O) device 1040, a power supply 1050, and a display device 1060. The display device 1060 may be the display device DD of FIG. 1. The electronic device 1000 may further include ports for communicating with a video card, a sound card, a memory card, a universal serial bus (USB) device, other systems, and the like.

In an embodiment of FIG. 29, the electronic device 1000 may be implemented as a smartphone. However, the electronic device 1000 of embodiments is not limited thereto. For example, the electronic device 1000 may be implemented as a smart pad, a smartwatch, a tablet PC, a car navigation system, a computer monitor, a laptop, a head mounted display (HMD) device, or the like.

The processor 1010 may perform various computing functions. The processor 1010 may be a microprocessor, a central processing unit (CPU), an application processor (AP), or the like. The processor 1010 may be coupled to other components through an address bus, a control bus, a data bus, and the like. In an embodiment, the processor 1010 may be coupled to an extended bus such as a peripheral component interconnection (PCI) bus. The processor 1010 may output the input image data IMG and the input signal CONT to the controller 200 of FIG. 2.

The memory device 1020 may store data for operations of the electronic device 1000. For example, the memory device 1020 may include at least one non-volatile memory device such as an erasable programmable read-only memory (EPROM) device, an electrically erasable programmable read-only memory (EEPROM) device, a flash memory device, a phase change random access memory (PRAM) device, a resistance random access memory (RRAM) device, a nano floating gate memory (NFGM) device, a polymer random access memory (PoRAM) device, a magnetic random access memory (MRAM) device, a ferroelectric random access memory (FRAM) device, and the like and/or at least one volatile memory device such as a dynamic random access memory (DRAM) device, a static random access memory (SRAM) device, a mobile DRAM device, or the like.

The storage device 1030 may include a solid-state drive (SSD) device, a hard disk drive (HDD) device, a CD-ROM device, or the like. The I/O device 1040 may include an input device such as a keyboard, a keypad, a mouse device, a touch-pad, a touch-screen, or the like, and an output device such as a printer, a speaker, or the like. In some embodiments, the I/O device 1040 may include the display device 1060.

The power supply 1050 may provide power for operations of the electronic device 1000. The display device 1060 may be electrically connected to other components through buses or other communication links.

As discussed, embodiments can provide a driver comprising: a first gate emission signal generator arranged to generate a first driving signal; a second gate emission signal generator arranged to generate a second driving signal different from the first driving signal, and wherein the second gate emission has a circuit structure substantially identical to a circuit structure of the first gate emission signal generator; a clock line which is disposed between the first gate emission signal generator and the second gate emission signal generator, wherein the clock line is arranged to output a clock signal; and a low voltage line which is disposed between the first gate emission signal generator and the second gate emission signal generator, wherein the low voltage line is arranged to output a first low gate voltage, wherein: the first gate emission signal generator is electrically connected to the clock line and the low voltage line, and the second gate emission signal generator is electrically connected to the clock line and the low voltage line to which the first gate emission signal generator is electrically connected.

In some embodiments, the low voltage line and the clock line are disposed in a same layer.

In some embodiments, the low voltage line and the clock line are disposed in different layers, and the low voltage line at least partially overlaps the clock line in a plan view.

Embodiments can provide a display device comprising: a display panel comprising a pixel; and a driver arranged to output a driving signal to the pixel, wherein the driver is according to any one of the above mentioned embodiments.

Embodiments can provide an electronic device comprising: a display device as set out in any one of the above mentioned embodiments; a controller arranged to output a control signal to the driver; and a processor arranged to output an input image data and an input signal to the controller.

Embodiments can provide an electronic device comprising: a display panel comprising a pixel; a driver arranged to output a driving signal to the pixel; a controller arranged to output a control signal to the driver; and a processor arranged to output an input image data and an input signal to the controller, wherein the driver comprises: a first gate emission signal generator arranged to generate a first driving signal; a second gate emission signal generator arranged to generate a second driving signal different from the first driving signal and has a circuit structure substantially identical to a circuit structure of the first gate emission signal generator; a clock line which is disposed between the first gate emission signal generator and the second gate emission signal generator and is arranged to output a clock signal; and a low voltage line which is disposed between the first gate emission signal generator and the second gate emission signal generator and is arranged to output a first low gate voltage, the first gate emission signal generator is electrically connected to the clock line and the low voltage line, and the second gate emission signal generator is electrically connected to the clock line and the low voltage line to which the first gate emission signal generator is electrically connected.

The disclosure may be applied to various display devices. For example, the disclosure is applicable to various display devices such as display devices for vehicles, ships and aircraft, portable communication devices, display devices for exhibition or information transmission, medical display devices, and the like.

The above description is an example of technical features of the disclosure, and those skilled in the art to which the disclosure pertains will be able to make various modifications and variations. Thus, the embodiments of the disclosure described above may be implemented separately or in combination with each other.

Therefore, the embodiments disclosed in the disclosure are not intended to limit the disclosure, but to describe the disclosure, and the scope of the disclosure is not limited by these embodiments. The protection scope of the disclosure should be interpreted by the following claims, and it should be interpreted that all technical teachings within the equivalent scope are included in the scope of the disclosure.

## Claims

1. A driver comprising:
a first gate emission signal generator arranged to generate a first driving signal;
a second gate emission signal generator arranged to generate a second driving signal different from the first driving signal, and wherein the second gate emission has a circuit structure substantially identical to a circuit structure of the first gate emission signal generator;
a clock line which is disposed between the first gate emission signal generator and the second gate emission signal generator, wherein the clock line is arranged to output a clock signal; and
a low voltage line which is disposed between the first gate emission signal generator and the second gate emission signal generator, wherein the low voltage line is arranged to output a first low gate voltage, wherein:
the first gate emission signal generator is electrically connected to the clock line and the low voltage line, and
the second gate emission signal generator is electrically connected to the clock line and the low voltage line to which the first gate emission signal generator is electrically connected.

2. The driver of claim 1, wherein
the driver comprises a plurality of stages disposed in a direction,
the first gate emission signal generator comprises a plurality of first gate emission signal generators;
the second gate emission signal generator comprises a plurality of second gate emission signal generators;
each of the plurality of stages comprises:
a corresponding first gate emission signal generator among the plurality of first gate emission signal generators; and
a corresponding second gate emission signal generator among the plurality of second gate emission signal generators, and
the clock line comprises:
a first clock line electrically connected to stages of the plurality of stages, which are disposed at odd-numbered rows; and
a second clock line electrically connected to stages of the plurality of stages, which are disposed at even-numbered rows.

3. The driver of claim 2, wherein the low voltage line is disposed between the first clock line and the second clock line in a plan view.

4. The driver of claim 2 or 3, wherein the low voltage line, the first clock line, and the second clock line are disposed in a same layer.

5. The driver of claim 2 or 3, wherein the low voltage line is disposed in a different layer from the first clock line and the second clock line.

6. The driver of claim 5, wherein the low voltage line at least partially overlaps the first clock line or the second clock line in a plan view; and/or
wherein the low voltage line is disposed under the first clock line and the second clock line.

7. The driver of any one of claims 1 to 6, wherein the first gate emission signal generator and the second gate emission signal generator are line-symmetrical with respect to the low voltage line.

8. The driver of any one of claims 1 to 7, wherein each of the first gate emission signal generator and the second gate emission signal generator comprises:
an input circuit arranged to output an input signal to a control node in response to the clock signal;
an inversion circuit arranged to invert a voltage of the control node, and arranged to output the inverted voltage to an inversion control node;
a carry signal output circuit arranged to output the first low gate voltage to a carry output node in response to the voltage of the control node, and arranged to output a high gate voltage to the carry output node in response to a voltage of the inversion control node; and
a driving signal output circuit arranged to output a second low gate voltage different from the first low gate voltage to a driving output node in response to the voltage of the control node, and arranged to output the high gate voltage to the driving output node in response to the voltage of the inversion control node.

9. The driver of claim 8, wherein the second low gate voltage is lower than the first low gate voltage.

10. A display device comprising:
a display panel comprising a pixel; and
a driver arranged to output a driving signal to the pixel, wherein
the driver is according to any one of claims 1 to 9.

11. The display device of claim 10, wherein the display panel comprises:
a pixel active pattern disposed on a substrate;
a pixel gate electrode disposed on the pixel active pattern;
a first pixel output electrode disposed on the pixel gate electrode;
a second pixel output electrode disposed on the pixel gate electrode;
a connection electrode disposed on the first pixel output electrode and the second pixel output electrode; and
a light-emitting element which is disposed on the connection electrode and emits light.

12. The display device of claim 11, wherein the low voltage line, the clock line, and the connection electrode are disposed in a same layer; or
wherein the low voltage line, the first pixel output electrode, and the second pixel output electrode are disposed in a same layer, and the clock line and the connection electrode are disposed in a same layer.

13. The display device of any one of claims 10 to 12, wherein the pixel comprises:
a light-emitting element arranged to emit light;
a first pixel transistor which provides a driving current to the light-emitting element;
a second pixel transistor arranged to provide a data voltage to the first pixel transistor in response to a write gate signal;
a third pixel transistor arranged to diode-connect the first pixel transistor in response to a compensation gate signal;
a fourth pixel transistor arranged to provide a first initialization voltage to a gate electrode of the first pixel transistor in response to an initialization gate signal;
a fifth pixel transistor arranged to provide a driving voltage to the first pixel transistor in response to an emission signal;
a sixth pixel transistor arranged to electrically connect the first pixel transistor and the light-emitting element in response to the emission signal; and
a seventh pixel transistor arranged to provide a second initialization voltage to a first electrode of the light-emitting element in response to a bias gate signal;
optionally wherein
the first driving signal is a driving signal selected from a group consisting of the emission signal, the compensation gate signal, the initialization gate signal, and the bias gate signal, and
the second driving signal is different from the first driving signal and is a driving signal selected from the group consisting of the emission signal, the compensation gate signal, the initialization gate signal, and the bias gate signal.

14. The display device of claim 13, wherein
the driver comprises:
a first driver; and
a second driver spaced apart from the first driver,
the first gate emission signal generator comprises a plurality of first gate emission signal generators,
the second gate emission signal generator comprises a plurality of second gate emission signal generators,
each of the first driver and the second driver comprises:
a corresponding first gate emission signal generator among the plurality of first gate emission signal generators; and
a corresponding second gate emission signal generator among the plurality of second gate emission signal generators,
the first driving signal of the first driver is the emission signal,
the second driving signal of the first driver is a gate signal selected from a group consisting of the compensation gate signal, the initialization gate signal, and the bias gate signal,
the first driving signal of the second driver is different from the second driving signal of the first driver and is a gate signal selected from the group consisting of the compensation gate signal, the initialization gate signal, and the bias gate signal, and
the second driving signal of the second driver is a gate signal different from the second driving signal of the first driver and the first driving signal of the second driver.

15. An electronic device comprising:
a display device as set out in any one of claims 10 to 14;
a controller arranged to output a control signal to the driver; and
a processor arranged to output an input image data and an input signal to the controller.
